# EUROPEAN PATENT APPLICATION

(11) **EP 3 578 583 A1**
(43) Date of publication of application: **11.12.2019**
(21) Application number: 18747536.3
(22) Date of filing: 06.02.2018
(51) Int. Cl.: C08G 61/00, C08G 61/12, G09F 9/30, H01L 51/50

(54) **BRANCHED POLYMER MANUFACTURING METHOD, BRANCHED POLYMER, AND ORGANIC ELECTRONIC ELEMENT**

(30) Priority: 06.02.2017 JP 2017004247
(71) Applicant: HITACHI CHEMICAL COMPANY, LTD., Chiyoda-ku Tokyo 100-6606 (JP)
(72) Inventor: ISHITSUKA, Kenichi, Tokyo 100-6606 (JP); SAKUMA, Hirotaka, Tokyo 100-6606 (JP); KAMO, Kazuyuki, Tokyo 100-6606 (JP); SUGIOKA, Tomotsugu, Tokyo 100-6606 (JP); YOSHINARI, Yuki, Tokyo 100-6606 (JP); HONNA, Ryo, Tokyo 100-6606 (JP); ASANO, Naoki, Tokyo 100-6606 (JP); FUKUSHIMA, Iori, Tokyo 100-6606 (JP); KODAMA, Shunsuke, Tokyo 100-6606 (JP); TAKAIRA, Hiroshi, Tokyo 100-6606 (JP); MORIYAMA, Ryota, Tokyo 100-6606 (JP)
(74) Representative: Beckmann, Claus
(86) International application number: PCT/JP2018/003894
(87) International publication number: WO 2018/143467

(57) **Abstract**

One embodiment relates to a branched polymer production method including reacting a monomer component containing at least reactive monomers (1) and (2) described below. The reactive monomer (1) has at least a conjugation unit and three or more reactive functional groups bonded to the conjugation unit, wherein the three or more reactive functional groups include two types of reactive functional groups that are mutually different. The reactive monomer (2) has at least a conjugation unit and two reactive functional groups bonded to the conjugation unit, wherein one of the two reactive functional groups is a group capable of reacting with one type of reactive functional group selected from among the two types of reactive functional groups, and the other of the two reactive functional groups is a group capable of reacting with the other type of reactive functional group selected from among the two types of reactive functional groups.

## Description

### Technical Field

The present disclosure relates to a branched polymer production method, a branched polymer, an organic electronic material, an ink composition, an organic layer, an organic electronic element, an organic electroluminescent element, a display element, an illumination device, and a display device.

### Background Art

Organic electronic elements are elements which use an organic substance to perform an electrical operation, and it is anticipated that such organic electronic elements will be capable of providing advantages such as lower energy consumption, lower prices and greater flexibility, meaning organic electronic elements are attracting much attention as a potential alternative technology to conventional inorganic semiconductors containing mainly silicon.

Examples of organic electronic elements include organic electroluminescent elements (organic EL elements), organic photoelectric conversion elements, and organic transistors.

Among the various organic electronic elements, organic EL elements are attracting attention for potential use in large-surface area solid state lighting applications to replace incandescent lamps or gas-filled lamps. Further, organic EL elements are also attracting attention as the leading self-luminous display for replacing liquid crystal displays (LCD) in the field of flat panel displays (FPD), and commercial products are becoming increasingly available.

Depending on the organic materials used, organic EL elements are broadly classified into two types: low-molecular weight type organic EL elements and polymer type organic EL elements. In polymer type organic EL elements, a polymer compound is used as the organic material, whereas in low-molecular weight type organic EL elements, a low-molecular weight compound is used. On the other hand, the production methods for organic EL elements are broadly classified into dry processes in which film formation is mainly performed in a vacuum system, and wet processes in which film formation is performed by plate-based printing such as relief printing or intaglio printing, or by plateless printing such as inkjet printing. Because wet processes enable simple film formation, they are expected to be an indispensable method in the production of future large-screen organic EL displays (for example, see Patent Document 1).

### Citation List

### Patent Literature

PLT 1: JP 2006-279007 A

### Summary of Invention

### Technical Problem

An organic EL element produced using wet processes has the advantages of facilitating cost reductions and increases in the element surface area. Polymers generally have excellent solubility in solvents, and are therefore suited to wet processes. However, organic EL elements produced using conventional polymers require further improvement in characteristics such as the drive voltage, the emission efficiency and the lifespan characteristics. This also applies to other organic electronic elements such as organic photoelectric conversion elements and organic transistors.

Accordingly, the present disclosure provides a branched polymer production method and a branched polymer that are suitable for improving the characteristics of organic electronic elements. Further, the present disclosure also provides an organic electronic material, an ink composition and an organic layer that are suitable for improving the characteristics of organic electronic elements. Moreover, the present disclosure also provides an organic electronic element, an organic electroluminescent element, a display element, an illumination device and a display device having excellent characteristics.

### Solution to Problem

The present invention includes various embodiments. Examples of these embodiments are described below. However, the present invention is not limited to the following embodiments.

One embodiment relates to a branched polymer production method that includes reacting a monomer component containing at least reactive monomers (1) and (2) described below.

The reactive monomer (1) has at least a conjugation unit and three or more reactive functional groups bonded to the conjugation unit, wherein the three or more reactive functional groups include two types of reactive functional groups that are mutually different.

The reactive monomer (2) has at least a conjugation unit and two reactive functional groups bonded to the conjugation unit, wherein one of the two reactive functional groups is a group that can react with one type of reactive functional group selected from among the two types of reactive functional groups described above, and the other of the two reactive functional groups is a group that can react with the other type of reactive functional group selected from among the two types of reactive functional groups described above.

Another embodiment relates to a branched polymer that contains a reaction product of a monomer component containing at least reactive monomers (1) and (2) described below (hereafter, this branched polymer is referred to as "the branched polymer P1").

The reactive monomer (1) has at least a conjugation unit and three or more reactive functional groups bonded to the conjugation unit, wherein the three or more reactive functional groups include two types of reactive functional groups that are mutually different.

The reactive monomer (2) has at least a conjugation unit and two reactive functional groups bonded to the conjugation unit, wherein one of the two reactive functional groups is a group that can react with one type of reactive functional group selected from among the two types of reactive functional groups described above, and the other of the two reactive functional groups is a group that can react with the other type of reactive functional group selected from among the two types of reactive functional groups described above.

Another embodiment relates to a branched polymer containing at least a partial structure (1) shown below (hereafter, this branched polymer is referred to as "the branched polymer P2"). In the present disclosure, "*" indicates a bonding site with another structure. 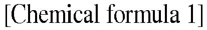 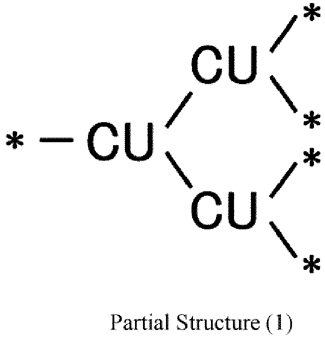 (In the formula, each CU independently represents a conjugation unit. Each conjugation unit may have a substituent.)

Another embodiment relates to an organic electronic material that contains a branched polymer obtained using the branched polymer production method described above, the branched polymer P1, or the branched polymer P2.

Another embodiment relates to an ink composition that contains a branched polymer obtained using the branched polymer production method described above, the branched polymer P1, the branched polymer P2, or the organic electronic material described above, and a solvent.

Another embodiment relates to an organic layer that contains a branched polymer obtained using the branched polymer production method described above, the branched polymer P1, the branched polymer P2, or the organic electronic material described above.

Another embodiment relates to an organic electronic element having at least one of the organic layer described above.

Another embodiment relates to an organic EL element having at least one of the organic layer described above.

Yet another embodiment relates to a display element or an illumination device that includes the organic EL element described above, or a display device that includes the above illumination device, and a liquid crystal element as a display unit.

### Advantageous Effects of Invention

The present disclosure can provide a branched polymer production method and a branched polymer that are suitable for improving the characteristics of organic electronic elements. Further, the present disclosure can also provide an organic electronic material, an ink composition and an organic layer that are suitable for improving the characteristics of organic electronic elements. Moreover, the present disclosure can also provide an organic electronic element, an organic EL element, a display element, an illumination device and a display device that have excellent characteristics.

### Brief Description of Drawings

FIG. 1 is a cross-sectional schematic view illustrating one example of an organic EL element of one embodiment.
FIG. 2 is a cross-sectional schematic view illustrating one example of an organic EL element of one embodiment.

### Description of Embodiments

Embodiments of the present invention are described below. However, the present invention is not limited to the following embodiments.

### <Branched Polymer Production Method>

According to one embodiment, the branched polymer production method includes reacting a monomer component containing at least the reactive monomers (1) and (2) described below.
[1] A reactive monomer (1) having at least a conjugation unit and three or more reactive functional groups bonded to the conjugation unit, wherein the three or more reactive functional groups include two types of reactive functional groups that are mutually different
[2] A reactive monomer (2) having at least a conjugation unit and two reactive functional groups bonded to the conjugation unit, wherein one of the two reactive functional groups is a group capable of reacting with one type of reactive functional group selected from among the two types of reactive functional groups described above, and the other of the two reactive functional groups is a group capable of reacting with the other type of reactive functional group selected from among the two types of reactive functional groups described above

By using this production method, a branched polymer containing a specific branched partial structure can be produced with ease. The obtained branched polymer can be used favorably as an organic electronic material. Further, the obtained branched polymer is able to improve the characteristics of organic electronic elements.

According to one embodiment, the monomer component described above may also contain the reactive monomer (3) and/or the reactive monomer (4) described below.
[3] A reactive monomer (3) having at least a conjugation unit and one reactive functional group bonded to the conjugation unit, wherein the one reactive functional group is capable of reacting with one type of reactive functional group selected from among the two types of reactive functional groups described above
[4] A reactive monomer (4) having at least a conjugation unit and two reactive functional groups bonded to the conjugation unit, wherein the two reactive functional groups are capable of reacting with one type of reactive functional group selected from among the two types of reactive functional groups described above

When the monomer component contains the reactive monomer (3), the introduction of substituents into the branched polymer can be performed with ease. Groups which, for example, can contribute to controlling the solubility, or contain a polymerizable functional group, are preferred as the substituent. Specific examples of groups that can contribute to controlling the solubility include linear, branched or cyclic alkyl groups, linear, branched or cyclic alkoxy groups, a phenoxy group, a hydroxyl group, a fluoro group, and linear, branched or cyclic perfluoroalkyl groups. Groups containing a polymerizable functional group are described below.

When the monomer component contains the reactive monomer (4), the introduction of substituents into the branched polymer can be performed with ease. Groups which, for example, can contribute to controlling the solubility are preferred as the substituent. Examples of these groups that can contribute to controlling the solubility are the same as those listed above. Further, when the monomer component contains the reactive monomer (4), the length of the polymer chain of the branched polymer can be easily extended. By adjusting the blend ratio of the reactive monomer (4), the molecular weight distribution can be controlled.

According to one embodiment, the branched polymer may have a polymerizable functional group. By including a polymerizable functional group, the branched polymer can be cured, enabling an organic layer having excellent solvent resistance to be obtained. By using an organic layer having excellent solvent resistance, a plurality of organic layers can be stacked with ease. The branched polymer may have the polymerizable functional group at a terminal portion of the polymer chain, at a portion other than a terminal, or at both a terminal portion and a portion other than a terminal. From the viewpoint of curability, the branched polymer preferably has the polymerizable functional group at least at a terminal portion, and from the viewpoint of achieving a favorable combination of curability and charge transportability, preferably has the polymerizable functional group only at terminal portions.

In order to introduce a polymerizable functional group at a terminal portion of the polymer chain, the reactive monomer (3) preferably includes the reactive monomer (3C) described below.
[5] A reactive monomer (3C) having at least a conjugation unit, one reactive functional group bonded to the conjugation unit, and a group containing one or more polymerizable functional groups that is bonded to the conjugation unit, wherein the one reactive functional group is capable of reacting with one type of reactive functional group selected from among the two types of reactive functional groups described above

### [Production Steps]

The branched polymer production method includes a step of reacting the monomer component. The reaction is preferably a coupling reaction. By using a coupling reaction, chemical bonds can be formed between conjugation units, either directly or via a linking group, enabling production of the desired conjugated polymer. For example, conventional coupling reactions such as the Suzuki coupling, Buchwald-Hartwig coupling, Negishi coupling, Stille coupling, Heck coupling and Sonogashira coupling reactions can be used. For example, in the Suzuki coupling, a Pd catalyst, Ni catalyst, or Ru catalyst or the like is used to initiate a coupling reaction between a boron-containing group bonded to a carbon atom and a halogen-containing group bonded to a carbon atom, thereby forming a carbon-carbon bond. Suzuki coupling is a method that enables aromatic rings to be easily bonded together, and is therefore particularly desirable. In the Buchwald-Hartwig coupling, a Pd catalyst or the like is used to initiate a coupling reaction between an amino group or hydroxyl group and a halogen-containing group bonded to a carbon atom, thereby forming a nitrogen-carbon bond or an oxygen-carbon bond.

The type of catalyst and solvent used in the coupling reaction, and other reaction conditions such as the temperature and the time are not particularly limited, and may be selected appropriately in accordance with the type of coupling reaction being performed. An example using Suzuki coupling is described below as one embodiment.

In the Suzuki coupling, examples of catalysts that may be used include Pd compounds such as Pd(0) compounds and Pd(II) compounds, Ni compounds, and Ru compounds. Specific examples of the Pd compounds include Pd compounds having phosphine ligands such as Pd(t-Bu₃P)₂ (bis(tri-tert-butylphosphine)palladium(0)), Pd(t-Bu₃P)₄ (tetrakis(tri-tert-butylphosphine)palladium(0)), Pd(PPh₃)₄ (tetrakis(triphenylphosphine)palladium(0)), Pd(dppf)Cl₂ ([1,1'-bis(diphenylphosphino)ferrocene]palladium(II) dichloride), and Pd(dppe)Cl₂ ([1,2-bis(diphenylphosphino)ethane]palladium(II) dichloride). Further, tris(dibenzylideneacetone)dipalladium(0) or palladium(II) acetate or the like may be used as a precursor, with a catalyst species being generated by mixing the precursor with a phosphine ligand within the reaction system. Examples of the phosphine ligand in this case include P(t-Bu)₃ (tris(t-butyl)phosphine), tributylphosphine, and P(c-Hex)₃ (tricyclohexylphosphine).

Mixed solvents of water and an organic solvent can be used favorably as the reaction solvent. Examples of the organic solvent include dimethoxyethane, toluene, anisole, tetrahydrofuran, acetone, acetonitrile and N,N-dimethylformamide. A base may also be used in the reaction, including alkali metal carbonates such as Na₂CO₃ and K₂CO₃, alkali metal hydroxides such as NaOH and KOH, alkali metal phosphates such as K₃PO₄, and water-soluble organic bases such as triethylamine, TMAH (tetramethylammonium hydroxide) and TEAH (tetraethylammonium hydroxide). Further, the reaction may also be accelerated by adding a phase transfer catalyst. Examples of the phase transfer catalyst include TBAB (tetrabutylammonium bromide) and Aliquat 336 (a registered trademark, manufactured by Sigma-Aldrich Corporation, a mixture of trioctylmethylammonium chloride and tricaprylylmethylammonium chloride).

The concentration of the monomer component (the concentration of the total of all the monomer components), relative to the mass of the reaction solvent, may be from 1 to 30% by mass, and is preferably from 2 to 25% by mass, and more preferably from 3 to 20% by mass. When the concentration of the monomer component is low, because the contact frequency between the monomer and the catalyst decreases, the molecular weight can be prevented from becoming too large, and gelling of the reaction solution or precipitation of the product can be more easily controlled. On the other hand, if the concentration of the monomer component is too low, then the volume of the reaction solution is large, and post-reaction processing and recovery of the branched polymer tend to become more complex. When the concentration of the monomer component is high, the contact frequency between the monomer and the catalyst increases and the reaction proceeds more readily, meaning a high-molecular weight branched polymer can be obtained more easily. On the other hand, if the concentration of the monomer component is too high, then the monomer tends to become difficult to dissolve in the solvent, or the solubility of the branched polymer tends to deteriorate, causing precipitate formation. An appropriate concentration may be selected with due consideration of the solubility of the monomer and the branched polymer, and the desired molecular weight and the like.

The catalyst concentration, based on the total number of moles of the monomer, may be from 0.01 to 5 mol%, and is preferably from 0.02 to 3 mol%, and more preferably from 0.03 to 1 mol%. When the catalyst concentration is low, the amount of catalyst residue retained in the branched polymer can be reduced. On the other hand, if the catalyst concentration is too low, then a satisfactory catalytic action is unobtainable, meaning the reaction reproducibility tends to deteriorate. When the catalyst concentration is high, because the catalytic action is adequate, favorable reaction reproducibility can be achieved. On the other hand, if the catalyst concentration is too high, then the amount of catalyst residue retained in the branched polymer tends to increase. An appropriate catalyst concentration may be selected with due consideration of the effects of catalyst residues, and the degree of reaction reproducibility and the like.

The reaction temperature may be set, for example, to 10 to 250°C, and is preferably from 20 to 200°C, and more preferably from 30 to 180°C. When the reaction temperature is low, the reaction is less likely to run out of control and the monomer is less likely to degrade. On the other hand, if the reaction temperature is too low, then a long time is required to produce the branched polymer. When the reaction temperature is high, the branched polymer can be produced quickly. On the other hand, if the reaction temperature is too high, then either the reaction tends to become difficult to control, or unwanted side-reactions tend to occur more readily. An appropriate reaction temperature may be selected with due consideration of the thermal stability of the monomer, and the desired control of the molecular weight of the branched polymer and the like.

The reaction time may be from 10 minutes to 48 hours, and is preferably from 30 minutes to 24 hours, and more preferably from 1 to 12 hours. When the reaction time is short, the branched polymer can be produced quickly. If the reaction time is too short, then the reaction tends not to proceed sufficiently. When the reaction time is long, the reaction is able to proceed adequately. However, if the reaction time is too long, then the production efficiency tends to deteriorate. An appropriate reaction time may be selected with due consideration of the time required for the reaction to proceed satisfactorily, and the reaction efficiency and the like.

The branched polymer is obtained as a reaction product of the monomer component containing the reactive monomers (1) and (2). In one embodiment, the production method may also include other optional steps. Examples of these optional steps include the types of steps typically used in polymer production, such as a step of recovering the branched polymer, a washing step, and a purification step.

### [Monomers]

The monomer component used in the production method contains at least the reactive monomer (1) and the reactive monomer (2), and may also contain the reactive monomer (3) and/or the reactive monomer (4). The "monomer component" is "a monomer mixture containing two or more types of monomers". There are no particular limitations on the conjugation unit and the reactive functional group contained in each reactive monomer, and any monomer may be used that suits the target branched polymer and the reaction method being used and the like. For example, in order to obtain a branched polymer having charge transport properties, a reactive monomer containing a conjugation unit that exhibits excellent charge transportability may be selected. Further, in the case of a production method that includes a step of performing a coupling reaction, a reactive monomer having a reactive functional group that can undergo a coupling reaction may be selected. The monomer component may contain only one type of each of the reactive monomer (1), the reactive monomer (2), the reactive monomer (3) and the reactive monomer (4), or may contain two or more types of each monomer. The monomer component may also contain other optional monomers.

### (Reactive Monomer (1))

The reactive monomer (1) has at least a conjugation unit and three or more reactive functional groups bonded to the conjugation unit. The three or more reactive functional groups include two types of mutually different reactive functional groups.

### (Conjugation Unit)

In one embodiment, the conjugation unit is an atom grouping having π electrons. The conjugation unit may have any skeleton that has π electrons, but preferably has a conjugated double bond. There are no particular limitations on the conjugation unit, but an atom grouping having an aromatic ring is preferred.

Examples of the aromatic ring include aromatic hydrocarbon rings and aromatic heterocycles.

Examples of the aromatic hydrocarbon rings include phenylene, naphthalene, anthracene, tetracene, fluorene, phenanthrene, 9,10-dihydrophenanthrene, triphenylene, pyrene and perylene.

Examples of the aromatic heterocycles include pyridine, pyrazine, quinoline, isoquinoline, carbazole, acridine, phenanthroline, furan, pyrrole, thiophene, oxazole, oxadiazole, thiadiazole, triazole, benzoxazole, benzoxadiazole, benzothiadiazole, benzotriazole and benzothiophene.

The conjugation unit may also be an atom grouping in which two or more aromatic rings are bonded together, either directly or via a carbon atom, an oxygen atom, or a nitrogen atom or the like. The upper limit for the number of aromatic rings is, for example, not more than 6, and is preferably not more than 4, and may be 3 for example.

The conjugation unit may have a substituent besides the reactive functional groups. This substituent is different from the reactive functional groups contained in the monomer. Examples of the substituent include a substituent (hereafter this substituent is sometimes referred to as "the substituent Ra") selected from the group consisting of -R¹ (excluding the case of a hydrogen atom), - OR², -SR³, -OCOR⁴, -COOR⁵, -SiR⁶R⁷R⁸, halogen atoms, and groups containing a polymerizable functional group described below. Each of R¹ to R⁸ independently represents a hydrogen atom, a linear, branched or cyclic alkyl group (preferably of 1 to 22 carbon atoms), an aryl group (preferably of 6 to 30 carbon atoms), or a heteroaryl group (preferably of 2 to 30 carbon atoms).

The linear, branched or cyclic alkyl group may be further substituted with an aryl group (preferably of 6 to 30 carbon atoms) and/or a heteroaryl group (preferably of 2 to 30 carbon atoms), and the aryl group or heteroaryl group may be further substituted with a linear, branched or cyclic alkyl group (preferably of 1 to 22 carbon atoms). Examples of the halogen atoms include a fluorine atom. The alkyl group, aryl group or heteroaryl group may be substituted with one or more halogen atoms, and examples include linear, branched or cyclic perfluoroalkyl groups (preferably of 1 to 22 carbon atoms).

In the present disclosure, the expression "linear, branched or cyclic alkyl group" means an atom grouping in which one hydrogen atom has been removed from a linear or branched saturated hydrocarbon, or an atom grouping in which one hydrogen atom has been removed from a cyclic saturated hydrocarbon.

In the present disclosure, an aryl group is an atom grouping in which one hydrogen atom has been removed from an aromatic hydrocarbon ring. A heteroaryl group is an atom grouping in which one hydrogen atom has been removed from an aromatic heterocycle.

In one embodiment, the conjugation unit may be an atom grouping that has an excellent ability to transport a positive hole or an electron. Although there are no particular limitations on this atom grouping, an atom grouping containing at least one structure selected from the group consisting of an aromatic amine structure, a carbazole structure and a thiophene structure is preferred. Hereafter, a unit containing at least one structure selected from the group consisting of an aromatic amine structure, a carbazole structures and a thiophene structure is termed a "charge transport unit". A branched polymer formed using a monomer containing a charge transport unit exhibits excellent characteristics as a charge transport polymer. The branched polymer may also contain conjugation units other than the charge transport unit. In those cases where the branched polymer contains a conjugation unit other than the charge transport unit, the charge transport properties and the number of introduced substituents and the like can be adjusted with ease.

For example, the conjugation unit other than the charge transport unit may be selected from structures represented by formulas (a1) to (a16) shown below. However, in the structures represented by formulas (a1) to (a16), the bonding sites (-*) for the reactive functional groups are not shown.

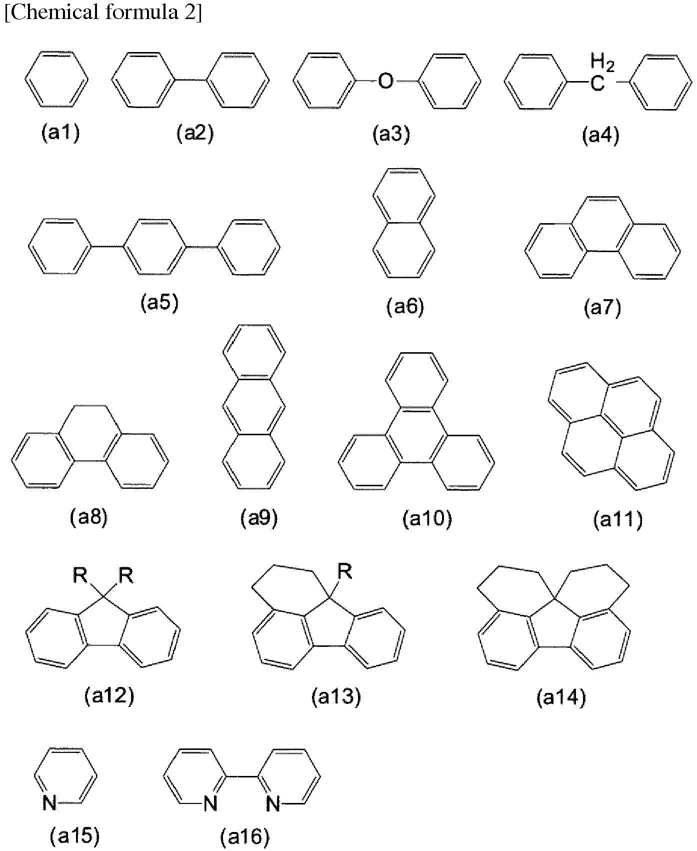

Each R independently represents a hydrogen atom or a substituent. Examples of the substituent include the substituent Ra described above.

The structures represented by formulas (a1) to (a16) may have a substituent at a substitutable position. Examples of the substituent include the substituent Ra described above.

For example, the charge transport unit may be selected from structures represented by formulas (b1) to (b58) shown below. However, in the structures represented by formulas (b1) to (b58), the bonding sites (-*) for the reactive functional groups are not shown.

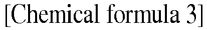

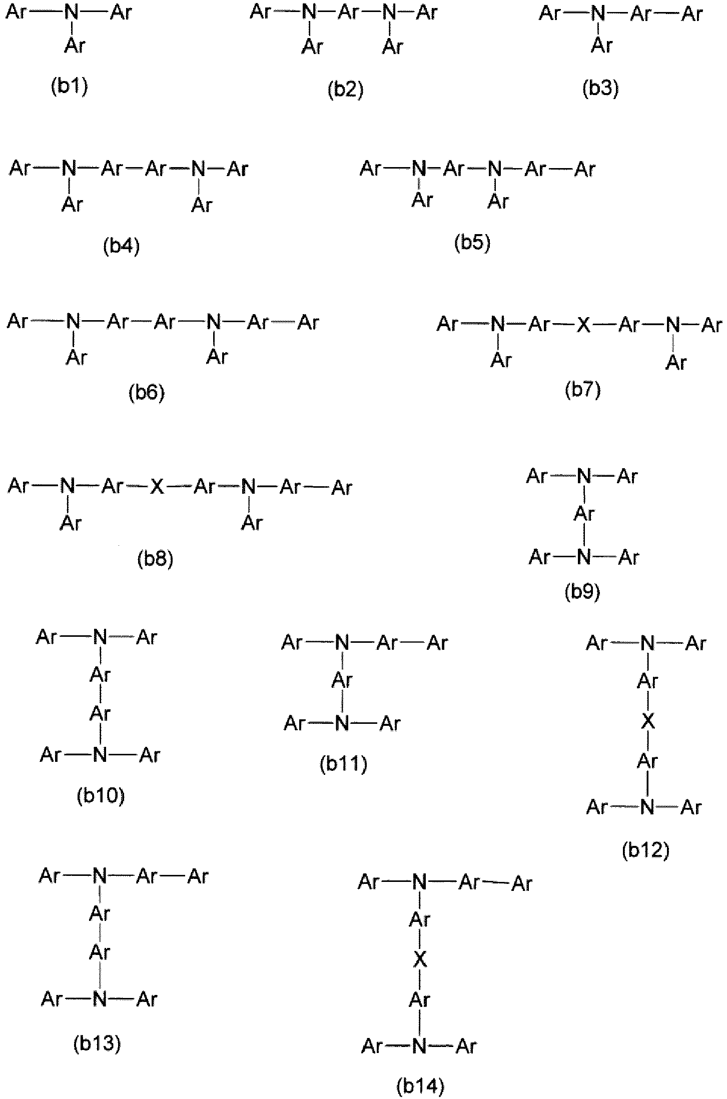

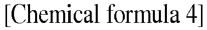

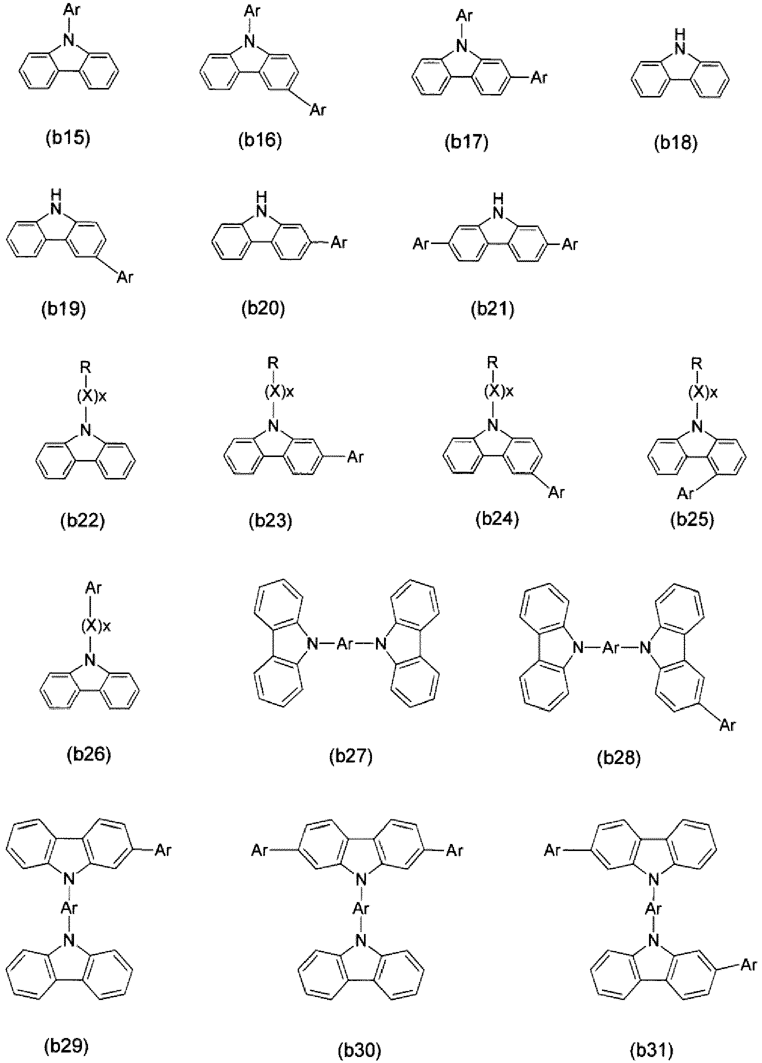

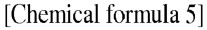

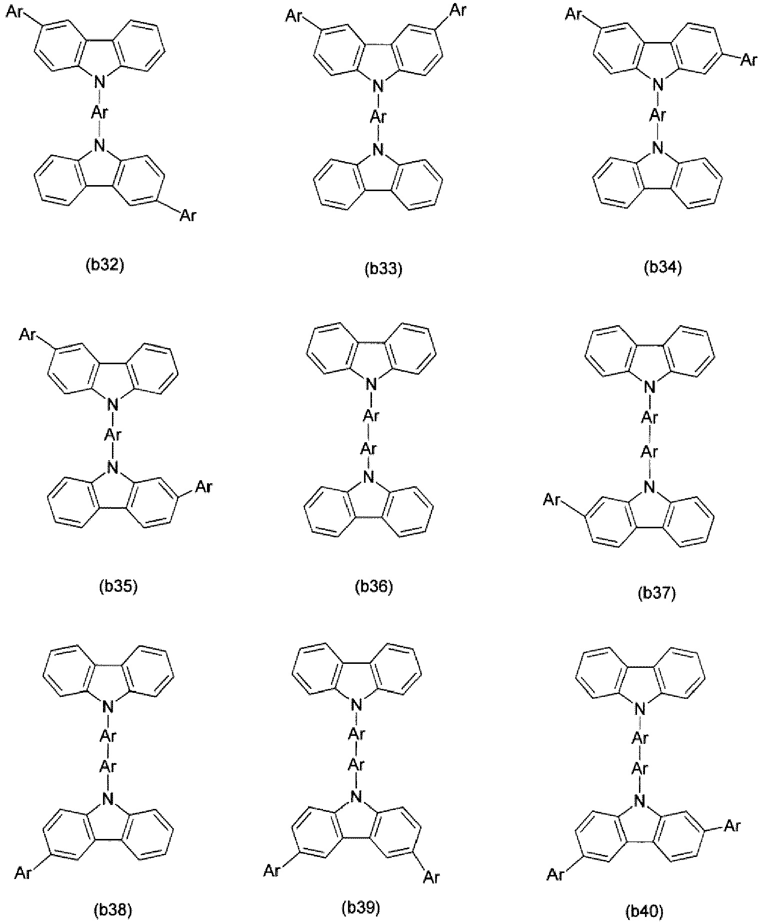

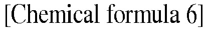

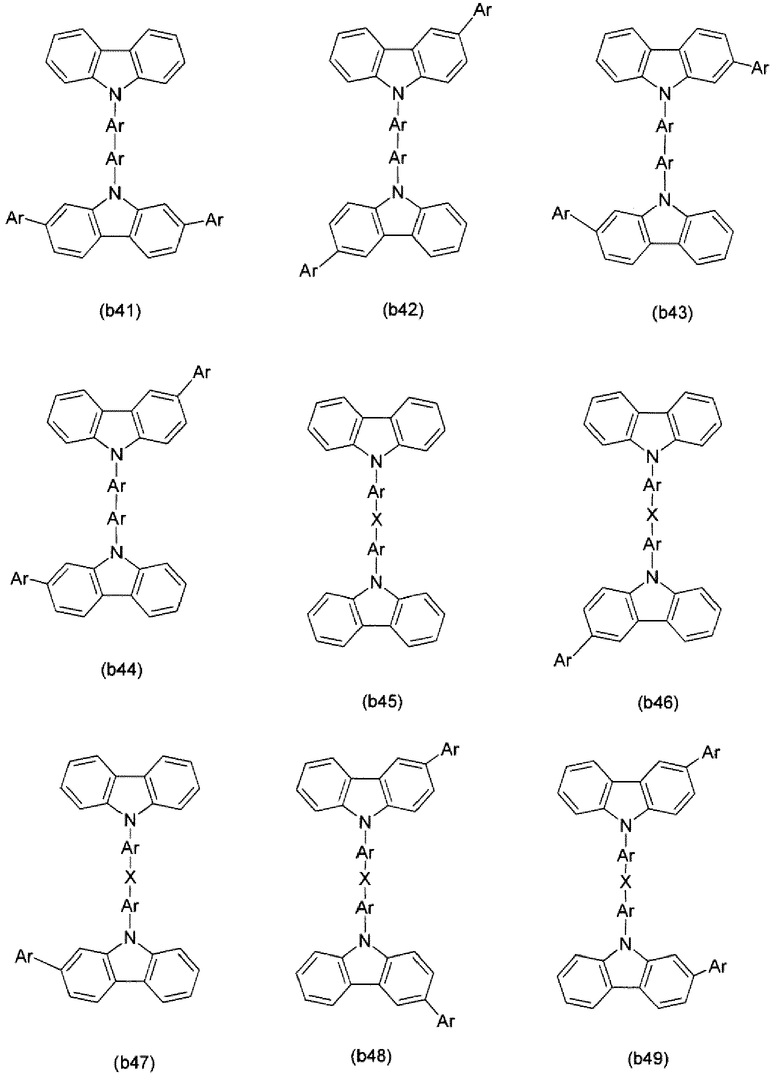

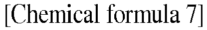

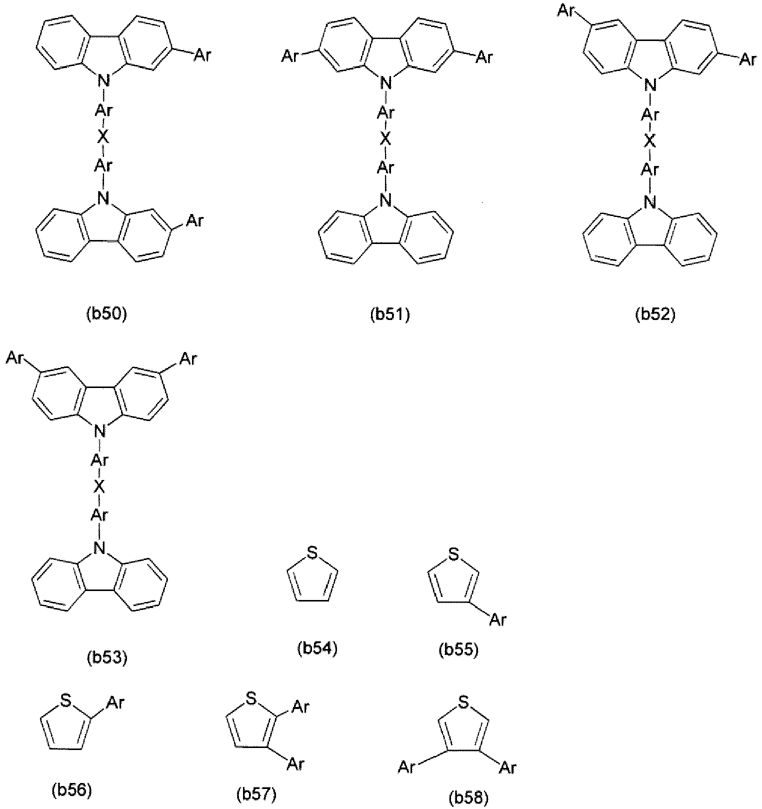

Each Ar independently represents an aryl group (preferably of 6 to 30 carbon atoms) or heteroaryl group (preferably of 2 to 30 carbon atoms), or an arylene group (preferably of 6 to 30 carbon atoms) or heteroarylene group (preferably of 2 to 30 carbon atoms).

Each X independently represents a divalent linking group. Although there are no particular limitations, X is preferably a group in which one hydrogen atom has been removed from a linear, branched or cyclic alkyl group (preferably of 1 to 22 carbon atoms), an aryl group (preferably of 6 to 30 carbon atoms) or a heteroaryl group (preferably of 2 to 30 carbon atoms) that has at least one hydrogen atom, or a group selected from a linking group set (c) described below.

Further, x represents an integer of 0 to 2.

Each R independently represents a hydrogen atom or a substituent. Examples of the substituent include the substituent Ra described above.

The structures represented by formulas (b1) to (b58) may have a substituent at a substitutable position. Examples of the substituent include the substituent Ra described above.

In the present disclosure, an arylene group is an atom grouping in which two hydrogen atoms have been removed from an aromatic hydrocarbon ring. A heteroarylene group is an atom grouping in which two hydrogen atoms have been removed from an aromatic heterocycle.

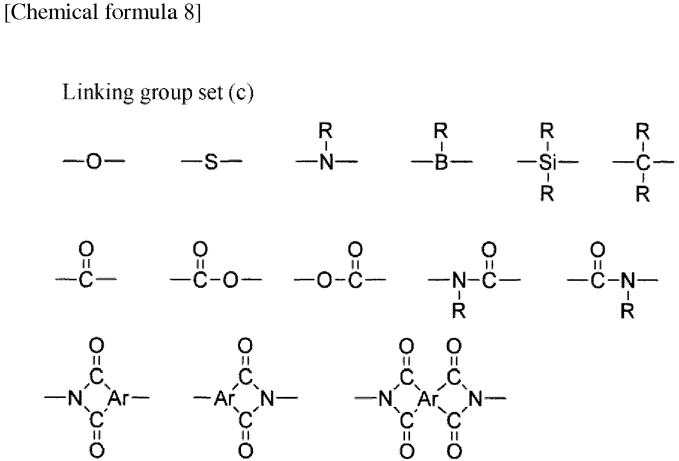

Each Ar independently represents an arene-triyl group (preferably of 6 to 30 carbon atoms) or heteroarene-triyl group (preferably of 2 to 30 carbon atoms), or an arene-tetrayl group (preferably of 6 to 30 carbon atoms) or heteroarene-tetrayl group (preferably of 2 to 30 carbon atoms).

Each R independently represents a hydrogen atom or a substituent. Examples of the substituent include the substituent Ra described above.

In the present disclosure, an arene-triyl group is an atom grouping in which three hydrogen atoms have been removed from an aromatic hydrocarbon ring. A heteroarene-triyl group is an atom grouping in which three hydrogen atoms have been removed from an aromatic heterocycle.

In the present disclosure, an arene-tetrayl group is an atom grouping in which four hydrogen atoms have been removed from an aromatic hydrocarbon ring. A heteroarene-tetrayl group is an atom grouping in which four hydrogen atoms have been removed from an aromatic heterocycle.

### (Group Containing a Polymerizable Functional Group)

In one embodiment, in order to enable the polymer to be cured by a polymerization reaction, thereby changing the degree of solubility in solvents, the branched polymer preferably has at least one group containing a polymerizable functional group. A "polymerizable functional group" refers to a functional group which is able to form bonds upon the application of heat and/or light.

Examples of the polymerizable functional group include groups having a carbon-carbon multiple bond (such as a vinyl group, styryl group, allyl group, butenyl group, ethynyl group, acryloyl group, acryloyloxy group, acryloylamino group, methacryloyl group, methacryloyloxy group, methacryloylamino group, vinyloxy group and vinylamino group), groups having a small ring (including cyclic alkyl groups such as a cyclopropyl group and cyclobutyl group; cyclic ether groups such as an epoxy group (oxiranyl group) and oxetane group (oxetanyl group); diketene groups; episulfide groups; lactone groups; lactam groups, and a benzocyclobutene group), and heterocyclic groups (such as a furanyl group, pyrrolyl group, thiophenyl group and silolyl group). Preferred polymerizable functional groups include groups having a carbon-carbon multiple bond and groups having a small ring, and of these, groups having a carbon-carbon double bond and cyclic ether groups are preferred. Particularly preferred groups include a vinyl group, styryl group, acryloyl group, acryloyloxy group, methacryloyl group, methacryloyloxy group, benzocyclobutene group, epoxy group and oxetane group, and from the viewpoints of improving the reactivity and the characteristics of organic electronic elements, a vinyl group, styryl group, benzocyclobutene group, oxetane group or epoxy group is even more preferred.

From the viewpoints of increasing the degree of freedom associated with the polymerizable functional group and facilitating the polymerization reaction, the main skeleton of the branched polymer and the polymerizable functional group are preferably linked via an alkylene chain. Further, in the case where, for example, an organic layer is to be formed on an electrode, from the viewpoint of enhancing the affinity with hydrophilic electrodes of ITO or the like, the main skeleton and the polymerizable functional group are preferably linked via a hydrophilic chain such as an ethylene glycol chain or a diethylene glycol chain. Moreover, from the viewpoint of simplifying preparation of the monomer used for introducing the polymerizable functional group, the branched polymer may have an ether linkage or an ester linkage at the terminal of the alkylene chain and/or the hydrophilic chain, namely, at the linkage site between these chains and the polymerizable functional group, and/or at the linkage site between these chains and the branched polymer skeleton. Examples of the "group containing a polymerizable functional group" include the polymerizable functional group itself, or a group containing a combination of the polymerizable functional group and an alkylene chain or the like. The polymerizable functional group may also have a substituent such as a linear, branched or cyclic alkyl group. Examples of groups that can be used favorably as this group containing a polymerizable functional group include the groups exemplified in WO 2010/140553.

### (Reactive Functional Groups)

The reactive monomer has "reactive functional groups" bonded to the conjugation unit. The reactive functional groups function as reaction sites, and by reacting together molecules of the reactive monomers, new bonds are formed between the conjugation units. The reactive functional groups are each preferably bonded to a carbon atom within the conjugation unit, and more preferably bonded to a carbon atom that adopts an sp² hybridized orbital.

The reactive monomer (1) has three or more reactive functional groups bonded to the conjugation unit. These three or more reactive functional groups include two types of mutually different reactive functional groups. Hereafter, these two types of reactive functional groups are termed the reactive functional group X1 and the reactive functional group Y1. The reactive functional group X1 and the reactive functional group Y1 are groups that can react together. By reacting the reactive functional group X1 of one reactive monomer (1) with the reactive functional group Y1 of another reactive monomer (1), a chemical bond is formed between the respective conjugation units, either directly or via a linking group. The three or more reactive functional groups preferably consist of the two types of mutually different reactive functional groups, and in such cases, the total number of the reactive functional group(s) X1 and the reactive functional group(s) Y1 is the same as the total number reactive functional groups contained in the reactive monomer (1). From the viewpoint of enabling favorable production of the branched polymer, or from the viewpoint of improving the characteristics of organic electronic elements, the total number of reactive functional groups contained in the reactive monomer (1) is preferably not more than 6, is more preferably 3 or 4, and is most preferably 3.

In one embodiment, in the case where two or more types of the reactive monomers (1) are used, it is preferable that the reactive monomers (1) have the same reactive functional group X1 and reactive functional group Y1. In other words, the two or more types of the reactive monomers (1) preferably differ in terms of the conjugation unit and/or substituents.

In those cases where the reaction is a coupling reaction, the reactive functional group X1 and the reactive functional group Y1 may be selected from among known groups that are able to form chemical bonds between conjugation units, either directly or via a linking group, as a result of the coupling reaction. Examples of preferred combinations of the reactive functional group X1 and the reactive functional group Y1 may be selected from among a halogen-containing group (X1) and a boron-containing group (Y1) in the case of Suzuki coupling, a halogen-containing group (X1) and an amino group or hydroxyl group (Y1) in the case of Buchwald-Hartwig coupling, a halogen-containing group (X1) and a zinc-containing group (Y1) in the case of Negishi coupling, a halogen-containing group (X1) and a tin-containing group (Y1) in the case of Stille coupling, a halogen-containing group (X1) and an ethenyl group (Y1) in the case of Heck coupling, and a halogen-containing group (X1) and an ethenyl group (Y1) in the case of Sonogashira coupling.

Among the various coupling reactions, Suzuki coupling is preferred. Accordingly, it is particularly preferable that the reactive functional group X1 is selected from among halogen-containing groups, and the reactive functional group Y1 is selected from among boron-containing groups. Examples of the halogen-containing group include a chloro group, a bromo group, a fluoro group, and a trifluoromethylsulfonyloxy group. Examples of the boron-containing group include a group represented by formula (d1) shown below. It is particularly preferable that the reactive functional group X1 is a bromo group, and the reactive functional group Y1 is a group represented by formula (d2) shown below. 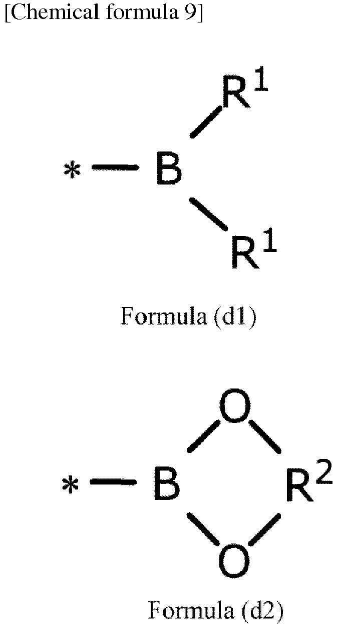
Each R¹ independently represents a hydroxyl group, a linear or branched alkyl group, or a linear or branched alkoxy group. The number of carbon atoms in the alkyl group or alkoxy group is preferably from 1 to 6. The two R¹ groups may be bonded together to form a ring.
R² represents a linear or branched alkylene group. The number of carbon atoms in the alkylene group is preferably from 1 to 12, more preferably from 1 to 10, and even more preferably from 2 to 6.

### (Structural Examples)

The reactive monomer (1) is, for example, represented by formula (1A) or formula (1B) shown below. 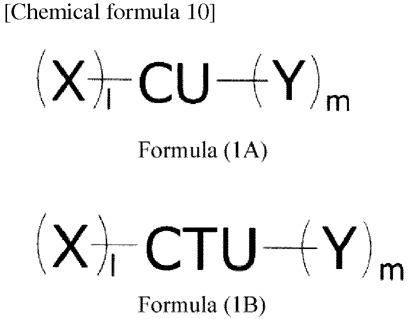
CU represents a conjugation unit, and CTU represents a charge transport unit. CU and CTU may each have a substituent.
X represents the reactive functional group X1, and Y represents the reactive functional group Y1.

Moreover, 1 is an integer of 1 or greater that indicates the number of X groups, and m is an integer of 1 or greater that indicates the number of Y groups, wherein 1+m≥ 3.

Examples of CU include charge transport units and other conjugation units besides charge transport units.

Examples of the substituent which CU and CTU may have include the substituent Ra described above.

X is preferably a group selected from among halogen-containing groups, is more preferably a halogen group, and is even more preferably a bromo group.

Y is preferably a group selected from among boron-containing groups, is more preferably a group represented by formula (d1), and is even more preferably a group represented by formula (d2).

Moreover, 1 is preferably an integer of 5 or less, and more preferably either 1 or 2. In addition, m is preferably an integer of 5 or less, and more preferably either 1 or 2. The value of 1+m is preferably an integer of 6 or less, and 1+m is more preferably 3 or 4.

In one embodiment, the reactive monomer (1) preferably has a charge transport unit, meaning the reactive monomer (1) is preferably represented by formula (1B).

CTU is preferably selected from among the structures represented by formulas (b1) to (b58), is more preferably selected from among the structures represented by formulas (b1), (b2), (b4), (b9), (b10), (b15) to (b17), and (b27) to (b35), and is even more preferably selected from among the structures represented by formulas (b1) and (b15).

### (Reactive Monomer (2))

The reactive monomer (2) has at least a conjugation unit and two reactive functional groups bonded to the conjugation unit.

### (Conjugation Unit)

The description relating to the "conjugation unit" in the reactive monomer (1) also applies to the "conjugation unit" in the reactive monomer (2).

### (Reactive Functional Groups)

Of the two reactive functional groups, one is a group that can react with one type of reactive functional group selected from among the two types of reactive functional groups in the reactive monomer (1), and the other is a group that can react with the other type of reactive functional group selected from among the two types of reactive functional groups. Hereafter, these two reactive functional groups are termed the reactive functional group X2 and the reactive functional group Y2. The reactive functional group X2 is a group that can react with the reactive functional group Y1, and the reactive functional group Y2 is a group that can react with the reactive functional group X1. It is preferable that the reactive functional group X2 and the reactive functional group Y2 are groups that are able to react together. By reacting the reactive functional group X2 and the reactive functional group Y1, the reactive functional group Y2 and the reactive functional group X1, and/or the reactive functional group X2 and the reactive functional group Y2, chemical bonds are formed between conjugation units, either directly or via a linking group. For example, the reactive functional group X2 is preferably the same group as the reactive functional group X1. For example, the reactive functional group Y2 is preferably the same group as the reactive functional group Y1. The reactive functional group X2 and/or the reactive functional group Y2 may be a group that can react with a reactive functional group Z3 and/or a reactive functional group Z4 described below.

In one embodiment, when two or more types of the reactive monomers (2) are used, it is preferable that the reactive monomers (2) have the same reactive functional groups X2 and the same reactive functional group Y2. In other words, the two or more types of the reactive monomers (2) preferably differ in terms of the conjugation unit and/or substituents.

The reactive functional group X2 and the reactive functional group Y2 are preferably independently selected from among halogen-containing groups and boron-containing groups, are more preferably selected from among a chloro group, a bromo group, a fluoro group, a trifluoromethylsulfonyloxy group, and a group represented by formula (d1), and are even more preferably selected from among a bromo group and a group represented by formula (d2).

### (Structural Examples)

The reactive monomer (2) is, for example, represented by formula (2A) or formula (2B) shown below.
[Chemical formula 11]

X-CU-Y Formula (2A)

X-CTU-Y Formula (2B)

CU represents a conjugation unit, and CTU represents a charge transport unit. CU and CTU may each have a substituent.
X represents the reactive functional group X2, and Y represents the reactive functional group Y2.

Examples of CU include charge transport units and other conjugation units besides charge transport units.

Examples of the substituent which CU and CTU may have include the substituent Ra described above.

X is preferably a group selected from among halogen-containing groups, is more preferably a halogen group, and is even more preferably a bromo group.

Y is preferably a group selected from among boron-containing groups, is more preferably a group represented by formula (d1), and is even more preferably a group represented by formula (d2).

In one embodiment, the reactive monomer (2) preferably has a charge transport unit, meaning the reactive monomer (2) is preferably represented by formula (2B).

CTU is preferably selected from among the structures represented by formulas (b1) to (b58), is more preferably selected from among the structures represented by formulas (b1) to (b8) and (b15) to (b26), and is even more preferably selected from among the structures represented by formulas (b1) to (b4) and (b15) to (b21).

### (Reactive Monomer (3))

The reactive monomer (3) has at least a conjugation unit and one reactive functional group bonded to the conjugation unit.

### (Conjugation Unit)

The description relating to the "conjugation unit" in the reactive monomer (1) also applies to the "conjugation unit" in the reactive monomer (3).

### (Reactive Functional Group)

The one reactive functional group is a group that can react with one type of reactive functional group selected from among the two types of reactive functional groups in the reactive monomer (1). Hereafter, this one reactive functional group is termed the reactive functional group Z3. The reactive functional group Z3 is a group that can react with the reactive functional group X1 or the reactive functional group Y1. It is preferable that the reactive functional group Z3 is a group that can also react with the reactive functional group X2 or the reactive functional group Y2. As a result of a "reaction between the reactive functional group Z3 and one of either the reactive functional group X1 or the reactive functional group Y1" and/or a "reaction between the reactive functional group Z3 and one of either the reactive functional group X2 and the reactive functional group Y2", a chemical bond is formed between conjugation units, either directly or via a linking group. For example, the reactive functional group Z3 is preferably the same group as either the reactive functional group Y1 or the reactive functional group X1, and is more preferably the same as the group among the reactive functional group Y1 and the reactive functional group X1 that is present in a smaller number within the reactive monomer (1). The reactive functional group Z3 may be a group that can react with the reactive functional group Z4 described below. In this case, the reactive functional group Z3 may be the same as the group among the reactive functional group Y1 and the reactive functional group X1 that is present in a larger number within the reactive monomer (1).

In one embodiment, when two or more types of the reactive monomers (3) are used, it is preferable that the reactive monomers (3) have the same reactive functional group Z3. In other words, the two or more types of the reactive monomers (3) preferably differ in terms of the conjugation unit and/or substituents.

The reactive functional group Z3 is preferably selected from among halogen-containing groups and boron-containing groups, is more preferably selected from among a chloro group, a bromo group, a fluoro group, a trifluoromethylsulfonyloxy group, and a group represented by formula (d1), and is even more preferably selected from among a bromo group and a group represented by formula (d2).

### (Reactive Monomer having Polymerizable Functional Group (3C))

In one embodiment, in order to impart the branched polymer with superior curability, the reactive monomer (3) preferably contains a reactive monomer (3C) having at least a conjugation unit, one reactive functional group bonded to the conjugation unit, and a group containing one or more polymerizable functional groups that is bonded to the conjugation unit. The reactive functional group and/or the group containing a polymerizable functional group are as described above.

### (Structural Examples)

The reactive monomer (3) is, for example, represented by formula (3A), formula (3B) or formula (3C) shown below.
[Chemical formula 12]

Z-CU Formula (3A)

Z-CTU Formula (3B)

Z-CLU Formula (3C)

CU represents a conjugation unit, CTU represents a charge transport unit, and CLU represents a conjugation unit having a group containing a polymerizable functional group (also called a cross-link unit). CU, CTU and CLU may each have a substituent.
Z represents the reactive functional group Z3.

Examples of CU include charge transport units and other conjugation units besides charge transport units. The CLU has a conjugation unit, and a group containing one or more polymerizable functional groups that is bonded to the conjugation unit.

Examples of the substituent which CU, CTU and CLU may have include the substituent Ra described above.

Z is preferably a group selected from among halogen-containing groups and boron-containing groups, is more preferably a group selected from among a halogen group and a group represented by formula (d1), and is even more preferably a group selected from among a bromo group and a group represented by formula (d2).

In one embodiment, the reactive monomer (3) preferably has a group containing a polymerizable functional group, meaning the reactive monomer (3) is preferably represented by formula (3C).

The conjugation unit in CLU is preferably a conjugation unit other than a charge transport unit, is more preferably selected from among the structures represented by formulas (a1) to (a16), and is even more preferably a structure represented by formula (a1). However, in formulas (a1) to (a16), the bonding site for the group containing a polymerizable functional group is not shown.

In the group containing a polymerizable functional group in CLU, the polymerizable functional group is preferably a group having a carbon-carbon multiple bond or a group having a small ring, and is more preferably a group having a carbon-carbon double bond or a cyclic ether group. Specifically, a vinyl group, styryl group, acryloyl group, acryloyloxy group, methacryloyl group, methacryloyloxy group, benzocyclobutene group, epoxy group or oxetane group is particularly preferred as the polymerizable functional group, and from the viewpoints of the reactivity and the characteristics of organic electronic elements, a vinyl group, styryl group, benzocyclobutene group, oxetane group or epoxy group is even more preferred.

### (Reactive Monomer (4))

The reactive monomer (4) has at least a conjugation unit and two reactive functional groups bonded to the conjugation unit.

### (Conjugation Unit)

The description relating to the "conjugation unit" in the reactive monomer (1) also applies to the "conjugation unit" in the reactive monomer (4).

### (Reactive Functional Groups)

The two reactive functional groups are groups that can react with one type of reactive functional group selected from among the two types of reactive functional groups in the reactive monomer (1). Hereafter, each of these two reactive functional groups is termed a reactive functional group Z4. The two reactive functional groups Z4 are both either groups that can react with the reactive functional group X1, or groups that can react with the reactive functional group Y1. It is preferable that the two reactive functional groups Z4 are groups that can also react with the reactive functional group X2 or the reactive functional group Y2. As a result of a "reaction between the reactive functional group Z4 and one of either the reactive functional group X1 or the reactive functional group Y1" and/or a "reaction between the reactive functional group Z4 and one of either the reactive functional group X2 and the reactive functional group Y2", a chemical bond is formed between conjugation units, either directly or via a linking group. One reactive functional group Z4 may be the same as, or different from, the other reactive functional group Z4. If consideration is given to the reactivity, then the reactive functional groups Z4 are preferably the same. For example, both of the two reactive functional groups Z4 are preferably the same group as either the reactive functional group Y1 or the reactive functional group X1, and are more preferably the same as the group among the reactive functional group Y1 and the reactive functional group X1 that is present in a smaller number within the reactive monomer (1). The reactive functional group Z4 may be a group that can react with the reactive functional group Z3. In this case, the reactive functional group Z4 may be the same as the group among the reactive functional group Y1 and the reactive functional group X1 that is present in a larger number within the reactive monomer (1).

In one embodiment, when two or more types of the reactive monomers (4) are used, it is preferable that the reactive monomers (4) have the same reactive functional groups Z4. In other words, the two or more types of the reactive monomers (4) preferably differ in terms of the conjugation unit and/or substituents.

The two reactive functional groups Z4 are both preferably selected from among halogen-containing groups and boron-containing groups, are more preferably selected from among a chloro group, a bromo group, a fluoro group, a trifluoromethylsulfonyloxy group and a group represented by formula (d1), and are even more preferably selected from among a bromo group and a group represented by formula (d2).

### (Structural Examples)

The reactive monomer (4) is, for example, represented by formula (4A) or formula (4B) shown below.
[Chemical formula 13]

Z-CU-Z Formula (4A)

Z-CTU-Z Formula (4B)

CU represents a conjugation unit, and CTU represents a charge transport unit. CU and CTU may each have a substituent.
Z represents the reactive functional group Z4.

Examples of CU include charge transport units and other conjugation units besides charge transport units.

Examples of the substituent which CU and CTU may have include the substituent Ra described above.

Z is preferably a group selected from among halogen-containing groups and boron-containing groups, is more preferably a group selected from among a halogen group and a group represented by formula (d1), and is even more preferably a group selected from among a bromo group and a group represented by formula (d2).

In one embodiment, the reactive monomer (4) preferably has a charge transport unit, meaning the reactive monomer (4) is preferably represented by formula (4B).

CTU is preferably selected from among the structures represented by formulas (b1) to (b58), is more preferably selected from among the structures represented by formulas (b1) to (b8) and (b15) to (b26), and is even more preferably selected from among the structures represented by formulas (b1) to (b4) and (b15) to (b21).

### (Proportions of Reactive Monomers)

From the viewpoint of realizing superior charge transport properties, the amount of the reactive monomer (1), based on the total number of moles of all the monomers, is preferably at least 10 mol%, more preferably at least 15 mol%, and even more preferably 20 mol% or greater. Further, from the viewpoint of controlling the solubility of the branched polymer, the amount of the reactive monomer (1), based on the total number of moles of all the monomers, is preferably not more than 90 mol%, more preferably not more than 80 mol%, and even more preferably 70 mol% or less.

From the viewpoint of realizing superior charge transport properties, the amount of the reactive monomer (2), based on the total number of moles of all the monomers, is preferably at least 10 mol%, more preferably at least 15 mol%, and even more preferably 20 mol% or greater. Further, from the viewpoints of adjusting the charge transportability and the energy levels and the like, the amount of the reactive monomer (2), based on the total number of moles of all the monomers, is preferably not more than 80 mol%, more preferably not more than 75 mol%, and even more preferably 70 mol% or less.

In those cases where the reactive monomer (3) is used, from the viewpoint of ensuring satisfactory curability, or from the viewpoint of adjusting the solubility, the amount of the reactive monomer (3), based on the total number of moles of all the monomers, is preferably at least 5 mol%, more preferably at least 10 mol%, and even more preferably 15 mol% or greater. Further, from the viewpoint of controlling the molecular weight, the amount of the reactive monomer (3), based on the total number of moles of all the monomers, is preferably not more than 80 mol%, more preferably not more than 70 mol%, and even more preferably 60 mol% or less.

In those cases where the reactive monomer (4) is used, from the viewpoint of improving the solubility of the branched polymer, the amount of the reactive monomer (4), based on the total number of moles of all the monomers, is preferably at least 0.1 mol%, more preferably at least 0.5 mol%, and even more preferably 1 mol% or greater. Further, from the viewpoint of controlling the molecular weight distribution, the amount of the reactive monomer (4), based on the total number of moles of all the monomers, is preferably not more than 50 mol%, more preferably not more than 45 mol%, and even more preferably 40 mol% or less.

In those cases where one or more reactive monomers having a charge transport unit are used, from the viewpoint of achieving superior charge transport properties, the amount of those monomers (for example, the total amount of the reactive monomers (1), (2), (3) and/or (4)), based on the total number of moles of all the monomers, is preferably at least 15 mol%, more preferably at least 20 mol%, and even more preferably 25 mol% or greater. Further, from the viewpoints of controlling the solubility and the molecular weight distribution and the like, the amount of reactive monomers having a charge transport unit, based on the total number of moles of all the monomers, is preferably not more than 90 mol%, more preferably not more than 80 mol%, and even more preferably 70 mol% or less.

In those cases where the reactive monomer (3) includes a reactive monomer (3C) having a polymerizable functional group, from the viewpoint of achieving satisfactory curability, the amount of that reactive monomer (3C), based on the total number of moles of the reactive monomer (3), is preferably at least 5 mol%, more preferably at least 10 mol%, and even more preferably 15 mol% or greater. Further, the amount of the reactive monomer (3C) having a polymerizable functional group, based on the total number of moles of the reactive monomer (3), may be 100 mol%, but from the viewpoint of enabling the introduction of substituents having other functions, is, for example, not more than 70 mol%, not more than 60 mol%, or 50 mol% or less.

The reactive monomers (3) and (4) can be obtained, for example, from Tokyo Chemical Industry Co., Ltd., or Sigma-Aldrich Japan Co., Ltd. or the like. Further, the reactive monomers (1) to (4) may also be synthesized using conventional methods.

### [Branched Polymer]

### (Number Average Molecular Weight (Mn))

The number average molecular weight of the branched polymer can be adjusted appropriately with due consideration of the solubility in solvents and the film formability and the like. From the viewpoint of ensuring superior charge transport properties, the number average molecular weight is preferably at least 500, more preferably at least 1,000, even more preferably at least 2,000, still more preferably at least 3,000, and particularly preferably 5,000 or greater. Further, from the viewpoints of maintaining favorable solubility in solvents and facilitating the preparation of ink compositions, the number average molecular weight is preferably not more than 1,000,000, more preferably not more than 500,000, even more preferably not more than 100,000, still more preferably not more than 50,000, and particularly preferably 30,000 or less.

### (Weight Average Molecular Weight (Mw))

The weight average molecular weight of the branched polymer can be adjusted appropriately with due consideration of the solubility in solvents and the film formability and the like. From the viewpoint of ensuring superior charge transport properties, the weight average molecular weight is preferably at least 1,000, more preferably at least 5,000, even more preferably at least 10,000, still more preferably at least 15,000, and particularly preferably 20,000 or greater. Further, from the viewpoints of maintaining favorable solubility in solvents and facilitating the preparation of ink compositions, the weight average molecular weight is preferably not more than 1,000,000, more preferably not more than 700,000, even more preferably not more than 400,000, still more preferably not more than 300,000, and particularly preferably 200,000 or less.

### (Dispersity (Mw/Mn))

From the viewpoint of ensuring superior charge transport properties, the dispersity of the branched polymer is preferably not more than 20.0, more preferably not more than 15.0, and even more preferably 10.0 or less. From the viewpoint of achieving particularly superior charge transport properties, the dispersity is, in order of preference, more preferably not more than 4.0, not more than 3.0, not more than 2.5, or 2.0 or less. The above range is also preferred from the viewpoint of obtaining favorable curability in those cases where the branched polymer has a polymerizable functional group. There are no particular limitations on the lower limit for the dispersity, which is, for example, 1.0 or greater.

The number average molecular weight and the weight average molecular weight can be measured by gel permeation chromatography (GPC) using a calibration curve of standard polystyrenes. For example, the measurement conditions may be set as follows.

### Apparatus:

High-performance liquid chromatograph "Prominence", manufactured by Shimadzu Corporation
Feed pump (LC-20AD)
Degassing unit (DGU-20A)
Autosampler (SIL-20AHT)
Column oven (CTO-20A)
PDA detector (SPD-M20A)
Refractive index detector (RID-20A)

### Columns:

Gelpack (a registered trademark)
GL-A160S (product number: 686-1J27)
GL-A150S (product number: 685-1J27)
manufactured by Hitachi Chemical Co., Ltd.

Eluent: Tetrahydrofuran (THF) (for HPLC, contains stabilizers), manufactured by Wako Pure Chemical Industries, Ltd.
Flow rate: 1 mL/min
Column temperature: 40°C
Detection wavelength: 254 nm
Molecular weight standards: PStQuick A/B/C, manufactured by Tosoh Corporation

### (Structure of Branched Polymer)

The branched polymer obtained using this production method preferably contains a branched partial structure formed by the bonding together of conjugation units contained in the reactive monomer (1). As a result of including this specific branched partial structure, the branched polymer can be used favorably as an organic electronic material. The branched polymer is able to improve the characteristics of organic electronic elements. It is thought that the specific branched partial structure contributes to an improvement in the quality of the organic layers or to an improvement in the charge transport properties.

Examples of the branched partial structure contained in the branched polymer include the partial structure (1) described below. Further, examples of the structure of the branched polymer include the structures described below as examples of the branched polymer P2.

Further, by using this production method, another effect that can be obtained is the ability to produce a branched polymer having a small dispersity. Branched polymers having a small dispersity enable suppression of variations in properties such as the charge transport properties and the solubility, and therefore the performance of organic electronic elements can be improved. Furthermore, by using this production method, another effect that can be obtained is the ability to provide a branched polymer of stable quality. In other words, by using this production method, variations between production lots of the branched polymer can also be suppressed. For example, even in those cases where the monomer blend ratio fluctuates during mass production, a branched polymer of similar molecular weight and molecular weight distribution can still be produced. This production method enables ready control of the molecular weight distribution and can stably provide a branched polymer having little variation in properties, and is a method that offers excellent productivity.

In one embodiment, a group having a polymerizable functional group can be introduced effectively into the branched polymer. Particularly in those cases where the group having a polymerizable functional group is introduced at terminals of the polymer chain, a branched polymer having particularly superior curability can be produced. Further, the fact that the obtained branched polymer has a narrow dispersity is also ideal for improving the curability.

### <Branched Polymer P1>

In one embodiment, a branched polymer P1 contains a reaction product of a monomer component containing at least the reactive monomer (1) described below.
[1] A reactive monomer (1) having at least a conjugation unit and three or more reactive functional groups bonded to the conjugation unit, wherein the three or more reactive functional groups include two types of reactive functional groups that are mutually different
[2] A reactive monomer (2) having at least a conjugation unit and two reactive functional groups bonded to the conjugation unit, wherein one of the two reactive functional groups is a group capable of reacting with one type of reactive functional group selected from among the two types of reactive functional groups described above, and the other of the two reactive functional groups is a group capable of reacting with the other type of reactive functional group selected from among the two types of reactive functional groups described above

The monomer component may also contain the reactive monomer (3) and/or the reactive monomer (4) described below.
[3] A reactive monomer (3) having at least a conjugation unit and one reactive functional group bonded to the conjugation unit, wherein the one reactive functional group is capable of reacting with one type of reactive functional group selected from among the two types of reactive functional groups described above
[4] A reactive monomer (4) having at least a conjugation unit and two reactive functional groups bonded to the conjugation unit, wherein the two reactive functional groups are capable of reacting with one type of reactive functional group selected from among the two types of reactive functional groups described above

The reactive monomer (3) may include a reactive monomer (3C) having a polymerizable functional group.
[5] A reactive monomer (3C) having at least a conjugation unit, one reactive functional group bonded to the conjugation unit, and a group containing one or more polymerizable functional groups that is bonded to the conjugation unit, wherein the one reactive functional group is capable of reacting with one type of reactive functional group selected from among the two types of reactive functional groups described above

The branched polymer P1 can be obtained using the branched polymer production method described above. The above description relating to the branched polymer production method may also be applied to the branched polymer P1. In other words, the reactive monomers (1) to (4), and the molecular weight and dispersity and the like of the branched polymer P1 are as described above in relation to the production method.

### <Branched Polymer P2>

In one embodiment, a branched polymer P2 contains at least the partial structure (1) represented by the formula shown below. 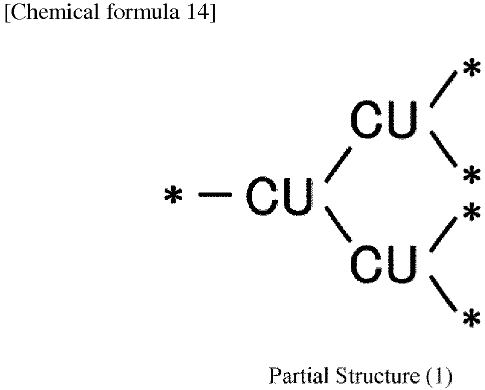 Each CU independently represents a conjugation unit.

Each conjugation unit may have a substituent, and examples of the substituent include the substituent Ra described above.

Each CU preferably independently represents a charge transport unit, is more preferably selected from among the structures represented by formulas (b1) to (b58), is even more preferably selected from among the structures represented by formulas (b1), (b2), (b4), (b9), (b10), (b15) to (b17) and (b27) to (b35), and is particularly preferably selected from among the structures represented by formulas (b1) and (b15).

The branched polymer P2 may contain the partial structure (2) represented by the formula shown below.
[Chemical formula 15]

* - CU - * Partial structure (2)

CU represents a conjugation unit.

The conjugation unit may have a substituent, and examples of the substituent include the substituent Ra described above. Depending on the production method used for producing the branched polymer P2, the conjugation unit may have the reactive functional group X1 described above or the reactive functional group Y1 described above or the like.

CU preferably represents a charge transport unit, is more preferably selected from among the structures represented by formulas (b1) to (b58), is even more preferably selected from among the structures represented by formulas (b1) to (b8) and (b15) to (b26), and is particularly preferably selected from among the structures represented by formulas (b1) to (b4) and (b15) to (b21).

The branched polymer P2 may also contain the partial structure (3) represented by the formula shown below.
[Chemical formula 16]

* -CU Partial structure (3)

CU represents a conjugation unit.

The conjugation unit may have a substituent, and examples of the substituent include the substituent Ra described above. Depending on the production method used for producing the branched polymer P2, the conjugation unit may have the reactive functional group X1 described above, the reactive functional group Y1 described above, the reactive functional group X2 described above, the reactive functional group Y2 described above, or the reactive functional group Z4 described above or the like.

The partial structure (3) preferably contains the partial structure (3C) represented by the formula shown below.
[Chemical formula 17]

* -CLU Partial structure (3C)

CLU represents a conjugation unit having a group containing a polymerizable functional group.

The conjugation unit may have a substituent, and examples of the substituent include the substituent Ra described above. Depending on the production method used for producing the branched polymer P2, the conjugation unit may have the reactive functional group X1 described above, the reactive functional group Y1 described above, the reactive functional group X2 described above, the reactive functional group Y2 described above, or the reactive functional group Z4 described above or the like.

The conjugation unit in CLU is preferably selected from among the structures represented by formulas (a1) to (a16), and is more preferably the structure represented by formula (a1).

In the group containing a polymerizable functional group within CLU, preferred examples of the polymerizable functional group include the groups exemplified above in the description of the reactive monomer (3C).

Descriptions within the above description of the branched polymer production method relating to the conjugation unit, the charge transport unit, CU, CTU, CLU, the reactive functional groups, and the method used for measuring the molecular weight and the like may also be applied to the branched polymer P2, provided no contradictions arise.

As a result of including the partial structure (1), the branched polymer P2 can be used favorably as an organic electronic material. The branched polymer P2 can improve the characteristics of organic electronic elements. It is thought that the partial structure (1) contributes to an improvement in the quality of the organic layers or to an improvement in the charge transport properties.

Further, in one embodiment, a group containing a polymerizable functional group can be introduced effectively into the branched polymer P2. In particular, by introducing the group having a polymerizable functional group at the terminals of the polymer chain of the branched polymer P2, superior curability can be achieved.

### (Proportions of Charge Transport Unit, Conjugation Unit, and Polymerizable Functional Group Unit)

In those cases where the branched polymer P2 contains a charge transport unit, from the viewpoint of achieving satisfactory charge transport properties, the proportion of that charge transport unit, based on the total of all the units, is preferably at least 10 mol%, more preferably at least 20 mol%, and even more preferably 30 mol% or greater. Further, the proportion of the charge transport unit may be 100 mol%, but if consideration is given to other conjugation units that may be introduced as required, the proportion is preferably not more than 95 mol%, more preferably not more than 90 mol%, and even more preferably 85 mol% or less.

In those cases where the branched polymer P2 contains a conjugation unit other than the charge transport unit, from the viewpoints of adjusting the charge transport properties and adjusting the number of introduced substituents and the like, the proportion of the other conjugation unit, based on the total of all the units, is preferably at least 1 mol%, more preferably at least 5 mol%, and even more preferably 10 mol% or greater. Further, from the viewpoints of facilitating the synthesis of the branched polymer and adjusting the charge transport properties and the like, the proportion of the conjugation unit other than the charge transport unit is preferably not more than 50 mol%, more preferably not more than 40 mol%, and even more preferably 30 mol% or less.

In those cases where the branched polymer P2 has a polymerizable functional group, from the viewpoint of enabling efficient curing of the branched polymer, the proportion of the polymerizable functional group, based on the total of all the units, is preferably at least 0.1 mol%, more preferably at least 1 mol%, and even more preferably 3 mol% or greater. Further, from the viewpoint of obtaining favorable charge transport properties, the proportion of the polymerizable functional group is preferably not more than 70 mol%, more preferably not more than 60 mol%, and even more preferably 50 mol% or less. Here, the "proportion of the polymerizable functional group" describes the proportion of the conjugation unit having the group containing the polymerizable functional group.

From the viewpoint of changing the degree of solubility, the polymerizable functional group is preferably included in the branched polymer P2 in a large amount. On the other hand, from the viewpoint of not impeding the charge transport properties, the amount included in the branched polymer is preferably kept small. The amount of the polymerizable functional group may be set as appropriate with due consideration of these factors. For example, from the viewpoint of obtaining a satisfactory change in the degree of solubility, the number of polymerizable functional groups per molecule of the branched polymer is preferably at least 2, and more preferably 3 or greater. Further, from the viewpoint of maintaining favorable charge transport properties, the number of polymerizable functional groups is preferably not more than 1,000, and more preferably 500 or fewer.

Considering the balance between the charge transport properties, the durability, and the productivity and the like, the ratio (molar ratio) between the charge transport unit and other conjugation units is preferably charge transport unit: other conjugation units = 100:(70 to 1), more preferably 100:(50 to 3), and even more preferably 100:(30 to 5).

Although dependent on the production method used for producing the branched polymer P2, the proportion of each unit can be determined, for example, using the amount added of the monomer corresponding with that unit during synthesis of the branched polymer. Further, the proportion of each unit can also be calculated as an average value using the integral of the spectrum attributable to that unit in the ¹H-NMR spectrum of the branched polymer P2. In terms of simplicity, if the amounts added of the monomers are clear, then the proportion of each unit preferably employs the value determined using the amount added of the corresponding monomer.

The number of polymerizable functional groups per molecule of the branched polymer P2 can be determined as an average value using the amount added of the polymerizable functional group (for example, the amount added of the monomer having the group containing a polymerizable functional group) during the synthesis of the branched polymer P2, the amounts added of the monomers corresponding with the various units, and the weight average molecular weight of the branched polymer P2 and the like. Further, the number of polymerizable functional groups can also be calculated as an average value using the ratio between the integral of the signal attributable to the polymerizable functional group and the integral of the entire spectrum in the ¹H-NMR (nuclear magnetic resonance) spectrum of the branched polymer P2, and the weight average molecular weight of the branched polymer P2 and the like. In terms of simplicity, if the amount added of the monomer is clear, then the value determined using that added amount is preferably employed.

### (Number Average Molecular Weight (Mn))

The number average molecular weight of the branched polymer P2 can be adjusted appropriately with due consideration of the solubility in solvents and the film formability and the like. From the viewpoint of ensuring superior charge transport properties, the number average molecular weight is preferably at least 500, more preferably at least 1,000, even more preferably at least 2,000, still more preferably at least 3,000, and particularly preferably 5,000 or greater. Further, from the viewpoints of maintaining favorable solubility in solvents and facilitating the preparation of ink compositions, the number average molecular weight is preferably not more than 1,000,000, more preferably not more than 500,000, even more preferably not more than 100,000, still more preferably not more than 50,000, and particularly preferably 30,000 or less.

### (Weight Average Molecular Weight (Mw))

The weight average molecular weight of the branched polymer P2 can be adjusted appropriately with due consideration of the solubility in solvents and the film formability and the like. From the viewpoint of ensuring superior charge transport properties, the weight average molecular weight is preferably at least 1,000, more preferably at least 5,000, even more preferably at least 10,000, still more preferably at least 15,000, and particularly preferably 20,000 or greater. Further, from the viewpoints of maintaining favorable solubility in solvents and facilitating the preparation of ink compositions, the weight average molecular weight is preferably not more than 1,000,000, more preferably not more than 700,000, even more preferably not more than 400,000, still more preferably not more than 300,000, and particularly preferably 200,000 or less.

### (Dispersity (Mw/Mn))

From the viewpoint of ensuring superior charge transport properties, the dispersity of the branched polymer P2 is preferably not more than 20.0, more preferably not more than 15.0, and even more preferably 10.0 or less. From the viewpoint of achieving particularly superior charge transport properties, the dispersity is, in order of preference, more preferably not more than 4.0, not more than 3.0, not more than 2.5, or 2.0 or less. The above range is also preferred from the viewpoint of obtaining favorable curability in those cases where the branched polymer P2 has a polymerizable functional group. There are no particular limitations on the lower limit for the dispersity, which is, for example, 1.0 or greater. A branched polymer P2 having a small dispersity enables suppression of variations in properties such as the charge transport properties and the solubility, and therefore the performance of organic electronic elements can be better stabilized.

There are no particular limitations on the method used for producing the branched polymer P2. Examples of the production method include methods that use a monomer having the partial structure (1), methods that include performing a graft polymerization, and the branched polymer production method described above. By using the branched polymer production method described above, a branched polymer P2 having a low dispersity can be produced. Further, the branched polymer production method described above also enables the branched polymer P2 to be produced simply and efficiently.

The branched polymer P2 may have only one type of the partial structure (1), or may have two or more types. This also applies to the partial structure (2) and the partial structure (3).

The branched polymer P2 may have the partial structure (1) as a portion of one of the structures shown below.

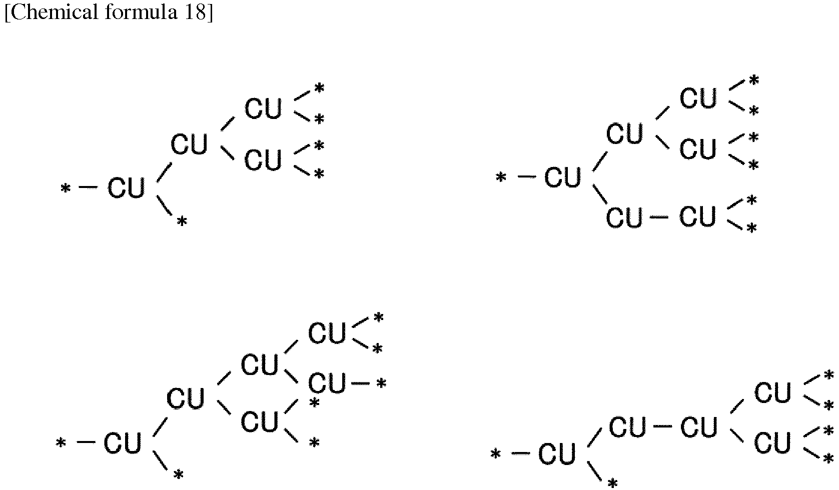

The branched polymer P2 may have the partial structure (2) as a portion of one of the structures shown below.

[Chemical formula 19] * -CU-CU- *

Examples of the structure of the branched polymer P2 are shown below. However, the structure of the branched polymer P2 is not limited to the following structures.

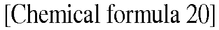

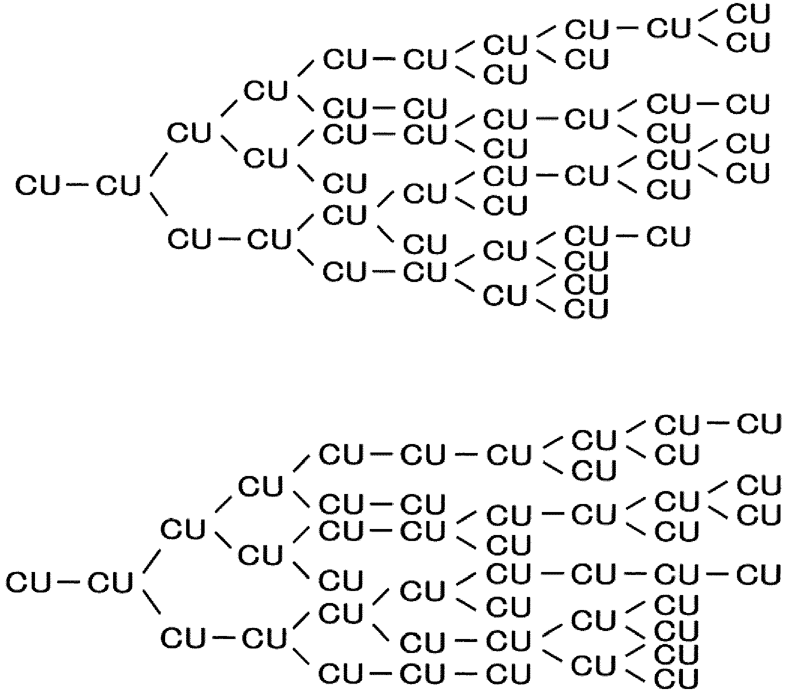

### <Organic Electronic Material>

According to one embodiment, an organic electronic material contains at least a branched polymer produced using the branched polymer production method described above, the branched polymer P1, or the branched polymer P2. By using a branched polymer, the element characteristics of organic electronic elements can be easily improved. The organic electronic material may have only one type of branched polymer, or may have two or more types.

### [Dopant]

The organic electronic material may also contain a dopant. There are no particular limitations on the dopant, provided it is a compound that yields a doping effect upon addition to the organic electronic material, enabling an improvement in the charge transport properties. Doping includes both p-type doping and n-type doping. In p-type doping, a substance that functions as an electron acceptor is used as the dopant, whereas in n-type doping, a substance that functions as an electron donor is used as the dopant. To improve the hole transport properties, p-type doping is preferably used, whereas to improve the electron transport properties, n-type doping is preferably used. The dopant used in the organic electronic material may be a dopant that exhibits either a p-type doping effect or an n-type doping effect. Further, a single type of dopant may be added alone, or a mixture of a plurality of dopant types may be added.

The dopants used in p-type doping are electron-accepting compounds, and examples include Lewis acids, protonic acids, transition metal compounds, ionic compounds, halogen compounds and π-conjugated compounds. Specific examples include Lewis acids such as FeCl₃, PF₅, AsF₅, SbF₅, BF₅, BCl₃ and BBr₃; protonic acids, including inorganic acids such as HF, HCl, HBr, HNO₅, H₂SO₄ and HClO₄, and organic acids such as benzenesulfonic acid, p-toluenesulfonic acid, dodecylbenzenesulfonic acid, polyvinylsulfonic acid, methanesulfonic acid, trifluoromethanesulfonic acid, trifluoroacetic acid, 1 -butanesulfonic acid, vinylphenylsulfonic acid and camphorsulfonic acid; transition metal compounds such as FeOCl, TiCl₄, ZrCl₄, HfCl₄, NbF₅. AlCl₃, NbCl₅, TaCl₅ and MoF₅; ionic compounds, including salts containing a perfluoro anion such as a tetrakis(pentafluorophenyl)borate ion, tris(trifluoromethanesulfonyl)methide ion, bis(trifluoromethanesulfonyl)imide ion, hexafluoroantimonate ion, AsF₆⁻ (hexafluoroarsenate ion), BF₄⁻ (tetrafluoroborate ion) or PF₆⁻ (hexafluorophosphate ion), and salts having a conjugate base of an aforementioned protonic acid as an anion; halogen compounds such as Cl₂, Br₂, I₂, ICl, ICl₃, IBr and IF; and π-conjugated compounds such as TCNE (tetracyanoethylene) and TCNQ (tetracyanoquinodimethane). Further, the electron-accepting compounds disclosed in JP 2000-36390 A, JP 2005-75948 A, and JP 2003-213002 A and the like can also be used. Lewis acids, ionic compounds, and π-conjugated compounds and the like are preferred.

The dopants used in n-type doping are electron-donating compounds, and examples include alkali metals such as Li and Cs; alkaline earth metals such as Mg and Ca; salts of alkali metals and/or alkaline earth metals such as LiF and Cs₂CO₃; metal complexes; and electron-donating organic compounds.

In those cases where the branched polymer has a polymerizable functional group, in order to make it easier to change the degree of solubility of the organic layer, the use of a compound that can function as a polymerization initiator for the polymerizable functional group as the dopant is preferred.

### [Other Optional Components]

The organic electronic material may also contain charge transport low-molecular weight compounds, or other polymers or the like.

### [Contents]

From the viewpoint of obtaining favorable charge transport properties, the amount of the branched polymer, relative to the total mass of the organic electronic material, is preferably at least 50% by mass, more preferably at least 70% by mass, and even more preferably 80% by mass or greater. The amount may be 100% by mass.

When a dopant is included, from the viewpoint of improving the charge transport properties of the organic electronic material, the amount of the dopant relative to the total mass of the organic electronic material is preferably at least 0.01% by mass, more preferably at least 0.1% by mass, and even more preferably 0.5% by mass or greater. Further, from the viewpoint of maintaining favorable film formability, the amount of the dopant relative to the total mass of the organic electronic material is preferably not more than 50% by mass, more preferably not more than 30% by mass, and even more preferably 20% by mass or less.

### <Ink Composition>

According to one embodiment, an ink composition contains at least a branched polymer produced using the branched polymer production method described above, the branched polymer P1 described above, the branched polymer P2 described above, or the organic electronic material described above, and a solvent that is capable of dissolving or dispersing these materials. The ink composition may, if necessary, also contain various conventional additives, provided the characteristics provided by the branched polymer are not impaired. By using an ink composition, an organic layer can be formed easily using a simple coating method.

### [Solvent]

Water, organic solvents, or mixed solvents thereof can be used as the solvent. Examples of the organic solvent include alcohols such as methanol, ethanol and isopropyl alcohol; alkanes such as pentane, hexane and octane; cyclic alkanes such as cyclohexane; aromatic hydrocarbons such as benzene, toluene, xylene, mesitylene, tetralin and diphenylmethane; aliphatic ethers such as ethylene glycol dimethyl ether, ethylene glycol diethyl ether and propylene glycol-1-monomethyl ether acetate; aromatic ethers such as 1,2-dimethoxybenzene, 1,3-dimethoxybenzene, anisole, phenetole, 2-methoxytoluene, 3-methoxytoluene, 4-methoxytoluene, 2,3-dimethylanisole, 2,4-dimethylanisole and diphenyl ether; aliphatic esters such as ethyl acetate, n-butyl acetate, ethyl lactate and n-butyl lactate; aromatic esters such as phenyl acetate, phenyl propionate, methyl benzoate, ethyl benzoate, propyl benzoate and n-butyl benzoate; amide-based solvents such as N,N-dimethylformamide and N,N-dimethylacetamide; as well as dimethyl sulfoxide, tetrahydrofuran, acetone, chloroform and methylene chloride and the like. Preferred solvents include aromatic hydrocarbons, aliphatic esters, aromatic esters, aliphatic ethers, and aromatic ethers and the like.

### [Polymerization Initiator]

In those cases where the branched polymer has a group containing a polymerizable functional group, the ink composition preferably contains a polymerization initiator. Conventional radical polymerization initiators, cationic polymerization initiators, and anionic polymerization initiators and the like can be used as the polymerization initiator. From the viewpoint of enabling simple preparation of the ink composition, the use of a substance that exhibits both a function as a dopant and a function as a polymerization initiator is preferred. Examples of such substances include the ionic compounds described above.

### [Additives]

The ink composition may also contain additives as optional components. Examples of these additives include polymerization inhibitors, stabilizers, thickeners, gelling agents, flame retardants, antioxidants, reduction inhibitors, oxidizing agents, reducing agents, surface modifiers, emulsifiers, antifoaming agents, dispersants and surfactants.

### [Contents]

The amount of the solvent in the ink composition can be determined with due consideration of the use of the composition in various coating methods. For example, the amount of the solvent is preferably an amount that yields a ratio of the branched polymer relative to the solvent that is at least 0.1% by mass, more preferably at least 0.2% by mass, and even more preferably 0.5% by mass or greater. Further, the amount of the solvent is preferably an amount that yields a ratio of the branched polymer relative to the solvent that is not more than 20% by mass, more preferably not more than 15% by mass, and even more preferably 10% by mass or less.

### <Organic Layer (Organic Thin Film)>

According to one embodiment, an organic layer contains a branched polymer produced using the branched polymer production method described above, the branched polymer P1 described above, the branched polymer P2 described above, or the organic electronic material described above. The branched polymer may be contained in the organic layer in the form of the branched polymer itself, or a derivative derived from the branched polymer such as a polymerization or reaction product. Similarly, the organic electronic material may be contained in the organic layer in the form of the organic electronic material itself, or a derivative derived from the organic electronic material such as a polymerization product, reaction product or decomposition product.

By using an ink composition, the organic layer can be formed favorably by a coating method. One example of a method for producing the organic layer includes a step of applying the ink composition. Examples of the coating method include conventional methods such as spin coating methods; casting methods; dipping methods; plate-based printing methods such as relief printing, intaglio printing, offset printing, lithographic printing, relief reversal offset printing, screen printing and gravure printing; and plateless printing methods such as inkjet methods.

The method for producing the organic layer may also include optional steps such as a step of drying the organic layer (namely, the coating layer) obtained following coating using a hot plate or an oven to remove the solvent, and a step of curing the coating layer.

In those cases where the branched polymer has a polymerizable functional group, the branched polymer can be subjected to a polymerization reaction by performing light irradiation or a heat treatment or the like, thereby changing the degree of solubility of the organic layer. By stacking another organic layer on top of an organic layer for which the degree of solubility has been changed, an organic electronic element having a multilayer structure can be produced with ease.

From the viewpoint of achieving charge transport properties, the thickness of the organic layer obtained following drying or curing is preferably at least 0.1 nm, more preferably at least 1 nm, and even more preferably 3 nm or greater. Further, from the viewpoint of reducing the electrical resistance, the thickness of the organic layer is preferably not more than 300 nm, more preferably not more than 200 nm, and even more preferably 100 nm or less.

### <Organic Electronic Element>

According to one embodiment, an organic electronic element has at least the organic layer described above. Examples of the organic electronic element include an organic EL element, an organic photoelectric conversion element, and an organic transistor. The organic electronic element preferably has at least a structure in which the organic layer is disposed between a pair of electrodes.

### <Organic EL Element>

According to one embodiment, an organic EL element has at least the organic layer described above. The organic EL element typically includes a light-emitting layer, an anode, a cathode and a substrate, and if necessary, may also have other functional layers such as a hole injection layer, electron injection layer, hole transport layer and electron transport layer. Each layer may be formed by a vapor deposition method, or by a coating method. The organic EL element preferably has the organic layer as the light-emitting layer or as another functional layer, more preferably has the organic layer as another functional layer, and even more preferably has the organic layer as at least one of a hole injection layer and a hole transport layer. In one embodiment, the organic EL element has at least a hole injection layer, wherein that hole injection layer is the organic layer described above. Further, in another embodiment, the organic EL element has at least a hole transport layer, wherein that hole transport layer is the organic layer described above. Moreover, the organic EL element may have at least a hole injection layer and a hole transport layer, wherein both layers are organic layers described above.

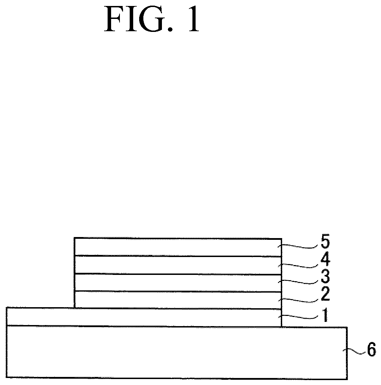

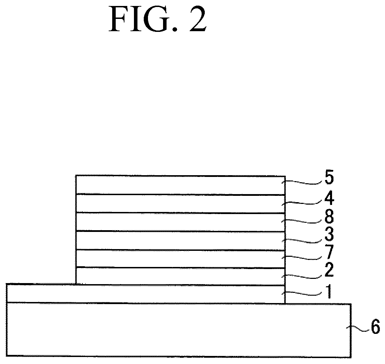

FIG. 1 and FIG. 2 are cross-sectional schematic views each illustrating an embodiment of the organic EL element. The organic EL element illustrated in FIG. 1 is an element with a multilayer structure, and has an anode 1, a hole injection layer 2, a light-emitting layer 3, an electron injection layer 4 and a cathode 5 provided in that order on top of a substrate 6. In one embodiment, the hole injection layer 2 is the organic layer described above.

The organic EL element illustrated in FIG. 2 is an element with a multilayer structure, and has an anode 1, a hole injection layer 2, a hole transport layer 7, a light-emitting layer 3, an electron transport layer 8, an electron injection layer 4 and a cathode 5 provided in that order on top of a substrate 6. In one embodiment, at least one of the hole injection layer 2 and the hole transport layer 7 is the organic layer described above. Each of the layers is described below.

### [Light-Emitting Layer]

Examples of materials that may be used in forming the light-emitting layer include light-emitting materials such as low-molecular weight compounds, polymers and dendrimers. Polymers exhibit good solubility in solvents, meaning they are suitable for coating methods, and are consequently preferred. Examples of the light-emitting material include fluorescent materials, phosphorescent materials, and thermally activated delayed fluorescent materials (TADF).

Specific examples of the fluorescent materials include low-molecular weight compounds such as perylene, coumarin, rubrene, quinacridone, stilbene, color laser dyes, aluminum complexes, and derivatives of these compounds; polymers such as polyfluorene, polyphenylene, polyphenylenevinylene, polyvinylcarbazole, fluorene-benzothiadiazole copolymers, fluorenetriphenylamine copolymers, and derivatives of these compounds; and mixtures of the above materials.

Examples of materials that can be used as the phosphorescent materials include metal complexes and the like containing a metal such as Ir or Pt or the like. Specific examples of Ir complexes include FIr(pic) (iridium(III) bis[(4,6-difluorophenyl)-pyridinato-N,C²]picolinate) which emits blue light, Ir(ppy)₃ (fac-tris(2-phenylpyridine)iridium) which emits green light, and (btp)₂Ir(acac) (bis[2-(2'-benzo[4,5-α]thienyl)pyridinato-N,C³]iridium(acetyl-acetonate)) and Ir(piq)₃ (tris(1-phenylisoquinoline)iridium) which emit red light. Specific examples of Pt complexes include PtOEP (2,3,7,8,12,13,17,18-octaethyl-21H,23H-porphyrin-platinum) which emits red light.

When the light-emitting layer contains a phosphorescent material, a host material is preferably also included in addition to the phosphorescent material. Low-molecular weight compounds, polymers, and dendrimers can be used as this host material. Examples of the low-molecular weight compounds include CBP (4,4'-bis(9H-carbazol-9-yl)-biphenyl), mCP (1,3-bis(9-carbazolyl)benzene), CDBP (4,4'-bis(carbazol-9-yl)-2,2'-dimethylbiphenyl), and derivatives of these compounds, whereas examples of the polymers include the organic electronic material described above, polyvinylcarbazole, polyphenylene, polyfluorene, and derivatives of these polymers.

Examples of the thermally activated delayed fluorescent materials include the compounds disclosed in Adv. Mater., 21, 4802-4906 (2009); Appl. Phys. Lett., 98, 083302 (2011); Chem. Comm., 48,9580 (2012); Appl. Phys. Lett., 101, 093306 (2012); J. Am. Chem. Soc., 134, 14706 (2012); Chem. Comm., 48, 11392 (2012); Nature, 492, 234 (2012); Adv. Mater., 25, 3319 (2013); J. Phys. Chem. A, 117,5607 (2013); Phys. Chem. Chem. Phys., 15, 15850 (2013); Chem. Comm., 49,10385 (2013); and Chem. Lett., 43, 319 (2014) and the like.

### [Hole Transport Layer, Hole Injection Layer]

Examples of materials that may be used in forming the hole transport layer or hole injection layer include the branched polymer described above or the organic electronic material described above. In one embodiment, at least one of the hole injection layer and the hole transport layer is preferably the organic layer described above. Further, both these layers may be organic layers described above.

Furthermore, examples of conventional materials that may be used include aromatic amine-based compounds (for example, aromatic diamines such as N,N'-di(naphthalen-1-yl)-N,N'-diphenyl-benzidine (a-NPD)), phthalocyanine-based compounds, and thiophene-based compounds (for example, thiophene-based conductive polymers such as poly(3,4-ethylenedioxythiophene):poly(4-styrenesulfonate) (PEDOT:PSS)).

### [Electron Transport Layer, Electron Injection Layer]

Examples of materials that may be used in forming the electron transport layer and the electron injection layer include phenanthroline derivatives, bipyridine derivatives, nitro-substituted fluorene derivatives, diphenylquinone derivatives, thiopyran dioxide derivatives, condensed-ring tetracarboxylic acid anhydrides of naphthalene and perylene and the like, carbodiimides, fluorenylidenemethane derivatives, anthraquinodimethane and anthrone derivatives, oxadiazole derivatives, thiadiazole derivatives, benzimidazole derivatives, quinoxaline derivatives, aluminum complexes, and lithium complexes. Further, the branched polymer described above and the organic electronic material described above may also be used.

### [Cathode]

Examples of the cathode material include metals or metal alloys, such as Li, Ca, Mg, Al, In, Cs, Ba, Mg/Ag, LiF and CsF.

### [Anode]

Metals (for example, Au) or other materials having conductivity may be used as the anode. Examples of the other materials include oxides (for example, ITO: indium oxide/tin oxide, and conductive polymers (for example, polythiophene-polystyrene sulfonate mixtures (PEDOT:PSS)).

### [Substrate]

Glass and plastics and the like can be used as the substrate. The substrate is preferably transparent, and preferably has flexibility. Quartz glass and light-transmitting resin films and the like can be used favorably.

Examples of the resin films include films containing polyethylene terephthalate, polyethylene naphthalate, polyethersulfone, polyetherimide, polyetheretherketone, polyphenylene sulfide, polyarylate, polyimide, polycarbonate, cellulose triacetate or cellulose acetate propionate.

In those cases where a resin film is used, an inorganic substance such as silicon oxide or silicon nitride may be coated onto the resin film to inhibit the transmission of water vapor and oxygen and the like.

### [Emission Color]

There are no particular limitations on the color of the light emission from the organic EL element. White organic EL elements can be used for various illumination fixtures, including domestic lighting, in-vehicle lighting, watches and liquid crystal backlights, and are consequently preferred.

The method used for forming a white organic EL element may employ a method in which a plurality of light-emitting materials are used to emit a plurality of colors simultaneously, which are then mixed to obtain a white light emission. There are no particular limitations on the combination of the plurality of emission colors, and examples include combinations that include three maximum emission wavelengths for blue, green and red, and combinations that include two maximum emission wavelengths for blue and yellow, or yellowish green and orange or the like. Control of the emission color can be achieved by appropriate adjustment of the types and amounts of the light-emitting materials.

### <Display Element, Illumination Device, Display Device>

According to one embodiment, a display element contains the organic EL element described above. For example, by using the organic EL element as the element corresponding with each color pixel of red, green and blue (RGB), a color display element can be obtained. Examples of the image formation method include a simple matrix in which organic EL elements arrayed in a panel are driven directly by an electrode arranged in a matrix, and an active matrix in which a thin-film transistor is positioned on, and drives, each element.

Furthermore, according to one embodiment, an illumination device contains the organic EL element described above. Moreover, according to another embodiment, a display device contains the illumination device and a liquid crystal element as a display unit. For example, the display device may be a device that uses the illumination device as a backlight, and uses a conventional liquid crystal element as the display unit, namely a liquid crystal display device.

### <Examples of Embodiments>

Examples of the embodiments are shown below. The embodiments of the present invention are not limited to the following examples.
[1] A branched polymer production method, comprising reacting a monomer component containing at least reactive monomers (1) and (2) described below:
   a reactive monomer (1) having at least a conjugation unit and three or more reactive functional groups bonded to the conjugation unit, wherein the three or more reactive functional groups include two types of reactive functional groups that are mutually different, and
   a reactive monomer (2) having at least a conjugation unit and two reactive functional groups bonded to the conjugation unit, wherein one of the two reactive functional groups is a group capable of reacting with one type of reactive functional group selected from among the two types of reactive functional groups, and the other of the two reactive functional groups is a group capable of reacting with the other type of reactive functional group selected from among the two types of reactive functional groups.
[2] The branched polymer production method according to [1] above, wherein the monomer component further comprises a reactive monomer (3) described below:
   a reactive monomer (3) having at least a conjugation unit and one reactive functional group bonded to the conjugation unit, wherein the one reactive functional group is capable of reacting with one type of reactive functional group selected from among the two types of reactive functional groups.
[3] The branched polymer production method according to [2] above, wherein the reactive monomer (3) comprises a reactive monomer (3C) described below:
   a reactive monomer (3C) having at least a conjugation unit, one reactive functional group bonded to the conjugation unit, and a group containing one or more polymerizable functional groups that is bonded to the conjugation unit, wherein the one reactive functional group is capable of reacting with one type of reactive functional group selected from among the two types of reactive functional groups.
[4] A branched polymer comprising a reaction product of a monomer component containing at least reactive monomers (1) and (2) described below:
   a reactive monomer (1) having at least a conjugation unit and three or more reactive functional groups bonded to the conjugation unit, wherein the three or more reactive functional groups include two types of reactive functional groups that are mutually different, and
   a reactive monomer (2) having at least a conjugation unit and two reactive functional groups bonded to the conjugation unit, wherein one of the two reactive functional groups is a group capable of reacting with one type of reactive functional group selected from among the two types of reactive functional groups, and the other of the two reactive functional groups is a group capable of reacting with the other type of reactive functional group selected from among the two types of reactive functional groups.
[5] The branched polymer according to [4] above, wherein the monomer component further comprises a reactive monomer (3) described below:
   a reactive monomer (3) having at least a conjugation unit and one reactive functional group bonded to the conjugation unit, wherein the one reactive functional group is capable of reacting with one type of reactive functional group selected from among the two types of reactive functional groups.
[6] The branched polymer according to [5] above, wherein the reactive monomer (3) comprises a reactive monomer (3C) described below:
   a reactive monomer (3C) having at least a conjugation unit, one reactive functional group bonded to the conjugation unit, and a group containing one or more polymerizable functional groups that is bonded to the conjugation unit, wherein the one reactive functional group is capable of reacting with one type of reactive functional group selected from among the two types of reactive functional groups.
[7] A branched polymer comprising at least a partial structure (1) shown below: 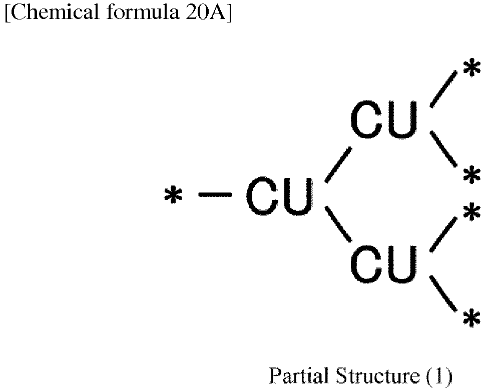 wherein each CU independently represents a conjugation unit, and each conjugation unit may have a substituent.
[8] The branched polymer according to [7] above, further comprising a partial structure (2) shown below:
   [Chemical formula 20B]

   *** - CU - *** Partial structure (2)

   wherein, CU represents a conjugation unit, and the conjugation unit may have a substituent.
[9] The branched polymer according to [7] or [8] above, further comprising a partial structure (3) shown below:
   [Chemical formula 20C]

   *** - CU** Partial structure (3)

   wherein CU represents a conjugation unit, and the conjugation unit may have a substituent.
[10] An organic electronic material comprising a branched polymer produced using the branched polymer production method according to any one of [1] to [3] above, or the branched polymer according to any one of [4] to [9] above.
[11] The organic electronic material according to [10] above, wherein the branched polymer has a polymerizable functional group, and the organic electronic material further comprises a polymerization initiator.
[12] The organic electronic material according to [10] or [11] above, further comprising an electron-accepting compound.
[13] An ink composition comprising a branched polymer produced using the branched polymer production method according to any one of [1] to [3] above, the branched polymer according to any one of [4] to [9] above, or the organic electronic material according to any one of [10] to [12] above, and a solvent.
[14] An organic layer formed using a branched polymer produced using the branched polymer production method according to any one of [1] to [3] above, the branched polymer according to any one of [4] to [9] above, the organic electronic material according to any one of [10] to [12] above, or the ink composition according to [13] above.
[15] An organic layer comprising a branched polymer produced using the branched polymer production method according to any one of [1] to [3] above, the branched polymer according to any one of [4] to [9] above, or the organic electronic material according to any one of [10] to [12] above.
[16] An organic electronic element comprising at least one of the organic layer according to [14] or [15] above.
[17] An organic electroluminescent element comprising at least one of the organic layer according to [14] or [15] above.
[18] An organic electroluminescent element comprising at least a hole injection layer, wherein the hole injection layer is the organic layer according to [14] or [15] above.
[19] An organic electroluminescent element comprising at least a hole transport layer, wherein the hole transport layer is the organic layer according to [14] or [15] above.
[20] A display element comprising the organic electroluminescent element according to any one of [17] to [19] above.
[21] An illumination device comprising the organic electroluminescent element according to any one of [17] to [19] above.
[22] A display device comprising the illumination device according to [21] above, and a liquid crystal element as a display unit.

The disclosure of the present invention is related to the subject matter disclosed in International Patent Application No. PCT/JP2017/004247, filed February 6, 2017, the entire contents of which are incorporated by reference herein.

### Examples

The present invention is described below in further detail using a series of examples, but the present invention is not limited by the following examples.

### <Production and Evaluation of Organic Electronic Materials and Organic EL Elements I>

### <Preparation of Branched Polymers>

### (Preparation of Pd Catalyst)

In a glove box under a nitrogen atmosphere at room temperature, tris(dibenzylideneacetone)dipalladium (73.2 mg, 80 µmol) was weighed into a sample tube, anisole (15 mL) was added, and the resulting mixture was agitated for 30 minutes. In a similar manner, tris(t-butyl)phosphine (129.6 mg, 640 µmol) was weighed into a sample tube, anisole (5 mL) was added, and the resulting mixture was agitated for 5 minutes. The two solutions were then mixed together and stirred for 30 minutes at room temperature to obtain a catalyst. All the solvents used were deaerated by nitrogen bubbling for at least 30 minutes prior to use.

### [Example 1]

### (Branched Polymer 1)

A three-neck round-bottom flask was charged with a monomer CTU-1 shown below (0.5 mmol), a monomer CTU-2 shown below (0.5 mmol), a monomer CLU-1 shown below (0.5 mmol), toluene (6.0 mL) and Aliquat 336 (a registered trademark) (10 mg), and the prepared Pd catalyst solution (0.1 mL) was then added. After stirring for 30 minutes, a 3 mol/L aqueous solution of potassium hydroxide (1 mL) was added. All of the solvents were deaerated by nitrogen bubbling for at least 30 minutes prior to use. The resulting mixture was heated and refluxed for 2 hours. All the operations up to this point were conducted under a stream of nitrogen.

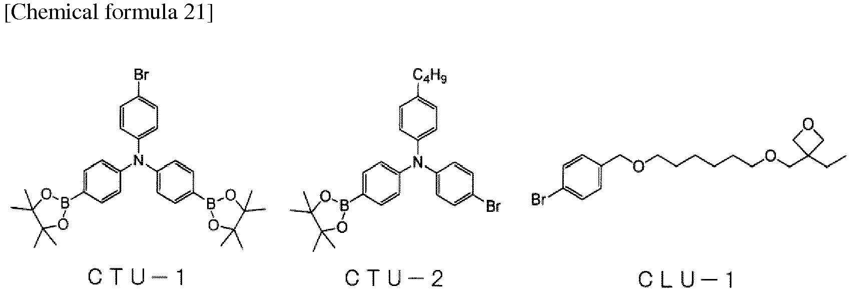

After completion of the reaction, the organic layer was washed with water, and was then poured into methanol-water (9:1). The resulting precipitate was collected by filtration under reduced pressure, and washed with methanol-water (9:1). The obtained precipitate was dissolved in toluene, and re-precipitated from methanol. The thus obtained precipitate was collected by filtration under reduced pressure and then dissolved in toluene, and a metal adsorbent ("Triphenylphosphine, polymer-bound on styrene-divinylbenzene copolymer", manufactured by Strem Chemicals Inc., 200 mg per 100 mg of the precipitate) was then added to the solution and stirred overnight. Following completion of the stirring, the metal adsorbent and other insoluble matter were removed by filtration, and the filtrate was concentrated using a rotary evaporator. The concentrate was dissolved in toluene, and then re-precipitated from methanol-acetone (8:3). The thus produced precipitate was collected by filtration under reduced pressure and washed with methanol-acetone (8:3). The thus obtained precipitate was then dried under vacuum to obtain a branched polymer 1.

The obtained branched polymer 1 had a number average molecular weight of 12,700, a weight average molecular weight of 30,000, and a dispersity of 2.35.

### [Example 2]

### (Branched Polymer 2)

With the exception of altering the monomers to the monomer CTU-1 shown above (0.6 mmol), the monomer CTU-2 shown above (0.5 mmol) and the monomer CLU-1 shown above (0.6 mmol), synthesis of a branched polymer 2 was performed in the same manner as Example 1. The obtained branched polymer 2 had a number average molecular weight of 12,500, a weight average molecular weight of 30,200, and a dispersity of 2.42.

### [Example 3]

### (Branched Polymer 3)

With the exception of altering the monomers to the monomer CTU-1 shown above (0.4 mmol), the monomer CTU-2 shown above (0.5 mmol) and the monomer CLU-1 shown above (0.4 mmol), synthesis of a branched polymer 3 was performed in the same manner as Example 1. The obtained branched polymer 3 had a number average molecular weight of 12,000, a weight average molecular weight of 34,500, and a dispersity of 2.87.

### [Example 4]

### (Branched Polymer 4)

With the exception of altering the monomers to the monomer CTU-1 shown above (0.3 mmol), the monomer CTU-2 shown above (0.5 mmol) and the monomer CLU-1 shown above (0.3 mmol), synthesis of a branched polymer 4 was performed in the same manner as Example 1. The obtained branched polymer 4 had a number average molecular weight of 10,600, a weight average molecular weight of 33,000, and a dispersity of 3.12.

### [Example 5]

### (Branched Polymer 5)

With the exception of altering the monomers to the monomer CTU-1 shown above (0.5 mmol), the monomer CTU-2 shown above (0.5 mmol), the monomer CLU-1 shown above (0.485 mmol) and a monomer CTU-3 shown below (0.015 mmol), synthesis of a branched polymer 5 was performed in the same manner as Example 1. The obtained branched polymer 5 had a number average molecular weight of 20,800, a weight average molecular weight of 53,400, and a dispersity of 2.56.

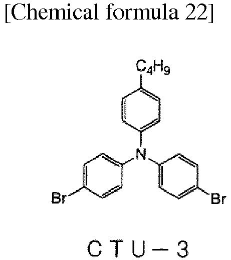

### [Comparative Example 1]

### (Branched Polymer 6)

With the exception of altering the monomers to a monomer CTU-4 shown below (0.2 mmol), a monomer CTU-5 shown above (0.5 mmol) and a monomer CLU-1 shown below (0.4 mmol), synthesis of a branched polymer 6 was performed in the same manner as Example 1. The obtained branched polymer 6 had a number average molecular weight of 7,900, a weight average molecular weight of 36,800, and a dispersity of 4.65.

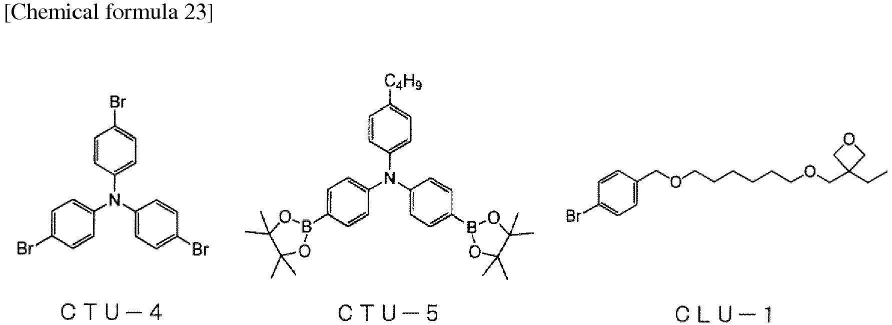

### [Comparative Example 2]

### (Branched Polymer 7)

With the exception of altering the monomers to the monomer CTU-4 shown above (0.16 mmol), the monomer CTU-5 shown above (0.5 mmol) and the monomer CLU-1 shown above (0.5 mmol), synthesis of a branched polymer 7 was performed in the same manner as Example 1. The obtained branched polymer 7 had a number average molecular weight of 3,300, a weight average molecular weight of 34,000, and a dispersity of 10.30.

### [Comparative Example 3]

### (Branched Polymer 8)

With the exception of altering the monomers to the monomer CTU-4 shown above (0.25 mmol), the monomer CTU-5 shown above (0.5 mmol) and the monomer CLU-1 shown above (0.25 mmol), synthesis of a branched polymer 8 was performed in the same manner as Example 1. The obtained branched polymer 8 had a number average molecular weight of 5,700, a weight average molecular weight of 170,000, and a dispersity of 29.82.

The monomers used in preparing the branched polymers, and the molecular weights and the like of the obtained branched polymers are summarized below in Table 1.

### [Table 1]

**Table 1**

| | Branched polymer | Monomers | Number average molecular weight | Weight average molecular weight | Dispersity |
|---|---|---|---|---|---|
| Example 1 | 1 | CTU-1 (0.5) | 12,700 | 30,000 | 2.35 |
| | | CTU-2 (0.5) | | | |
| | | CLU-1 (0.5) | | | |
| Example 2 | 2 | CTU-1 (0.6) | 12,500 | 30,200 | 2.42 |
| | | CTU-2 (0.5) | | | |
| | | CLU-1 (0.6) | | | |
| Example 3 | 3 | CTU-1 (0.4) | 12,000 | 34,500 | 2.87 |
| | | CTU-2 (0.5) | | | |
| | | CLU-1 (0.4) | | | |
| Example 4 | 4 | CTU-1 (0.3) | 10,600 | 33,000 | 3.12 |
| | | CTU-2 (0.5) | | | |
| | | CLU-1 (0.3) | | | |
| Example 5 | 5 | CTU-1 (0.5) | 20,800 | 53,400 | 2.56 |
| | | CTU-2 (0.5) | | | |
| | | CTU-3 (0.015) | | | |
| | | CLU-1 (0.485) | | | |
| Comparative Example 1 | 6 | CTU-4 (0.2) | 7,900 | 36,800 | 4.65 |
| | | CTU-5 (0.5) | | | |
| | | CLU-1 (0.4) | | | |
| Comparative Example 2 | 7 | CTU-4 (0.16) | 3,300 | 34,000 | 10.30 |
| | | CTU-5 (0.5) | | | |
| | | CLU-1 (0.5) | | | |
| Comparative Example 3 | 8 | CTU-4 (0.25) | 5,700 | 170,000 | 29.82 |
| | | CTU-5 (0.5) | | | |
| | | CLU-1 (0.25) | | | |

Based on the molecular weights and numbers and types of reactive functional groups in the monomers used, and the molecular weight values of the branched polymers, it was assumed that the branched polymers 1 to 5 each had a partial structure (1). The branched polymers 1 to 5 each had a small dispersity regardless of the monomer blend ratio, and variations in the molecular weight and dispersity values between the branched polymers 1 to 5 were small.

### <Production and Evaluation of Organic EL Elements>

The following examples relate to embodiments in which an organic layer (organic thin film) formed using an organic electronic material (an ink composition) containing a branched polymer was used for the hole injection layer of an organic EL element.

### [Example 6]

Under a nitrogen atmosphere, the branched polymer 1 (10.0 mg), an ionic compound 1 shown below (0.5 mg) and toluene (2.3 mL) were mixed together to prepare an ink composition. The ink composition was spin-coated at a rotational rate of 3,000 min⁻¹ onto a glass substrate on which ITO had been patterned with a width of 1.6 mm, and was then cured by heating at 230°C for 30 minutes on a hot plate, thus forming a hole injection layer (30 nm).

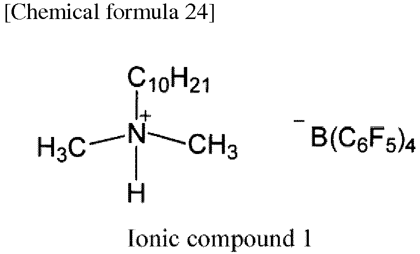

The glass substrate was transferred into a vacuum deposition apparatus, and layers of α-NPD (40 nm), CBP:Ir(ppy)₃ (94:6, 30 nm), BAlq (10 nm), TPBi (30 nm), Liq (2.0 nm) and Al (150 nm) were deposited in that order on top of the hole injection layer using deposition methods. An encapsulation treatment was then performed to complete production of an organic EL element.

### [Examples 7 to 10, and Comparative Examples 4 to 6]

With the exception of replacing the branched polymer 1 with the branched polymer shown below in Table 2 in the formation step for the hole injection layer, an organic EL element was produced in the same manner as Example 6.

The organic electronic materials used in forming the hole injection layer in the organic EL elements of Examples 6 to 10 and Comparative Examples 4 to 6 are shown in Table 2.

### [Table 2]

**Table 2**

| | Organic electronic material |
|---|---|
| Example 6 | Branched polymer 1, ionic compound 1 |
| Example 7 | Branched polymer 2, ionic compound 1 |
| Example 8 | Branched polymer 3, ionic compound 1 |
| Example 9 | Branched polymer 4, ionic compound 1 |
| Example 10 | Branched polymer 5, ionic compound 1 |
| Comparative Example 4 | Branched polymer 6, ionic compound 1 |
| Comparative Example 5 | Branched polymer 7, ionic compound 1 |
| Comparative Example 6 | Branched polymer 8, ionic compound 1 |

When a voltage was applied to the organic EL elements obtained in Examples 6 to 10 and Comparative Examples 4 to 6, green light emission was confirmed in each case. For each organic EL element, the emission efficiency at a luminance of 5,000 cd/m² and the emission lifespan (luminance half-life) when the initial luminance was 5,000 cd/m² were measured. The measurement results are shown in Table 3. Measurement of the luminance was performed using a spectroradiometer SR-3AR manufactured by Topcon Technohouse Corporation.

### [Table 3]

**Table 3**

| | Emission efficiency (cd/A) | Emission efficiency Δ (difference between maximum and minimum) | Emission lifespan (h) | Emission lifespan Δ (difference between maximum and minimum) |
|---|---|---|---|---|
| Example 6 | 29.9 | 0.2 | 399.2 | 5.9 |
| Example 7 | 29.8 | | 395.4 | |
| Example 8 | 29.9 | | 396.3 | |
| Example 9 | 29.8 | | 398.9 | |
| Example 10 | 30.0 | | 401.3 | |
| Comparative Example 4 | 28.2 | 0.3 | 353.4 | 19.8 |
| Comparative Example 5 | 28.1 | | 342.4 | |
| Comparative Example 6 | 28.4 | | 362.2 | |

As illustrated in Table 3, in each of Examples 6 to 10, a long-life organic EL element having excellent drive stability was able to be obtained. Further, in Examples 6 to 10, superior emission efficiency results were also obtained. Furthermore, in Examples 6 to 10, the variation across Examples 6 to 10 was small. Variation in the emission lifespan was particularly well suppressed.

### <Production and Evaluation of Organic Electronic Materials and Organic EL Elements II>

### <Preparation of Branched Polymers>

### [Example 11]

### (Branched Polymer 9)

A three-neck round-bottom flask was charged with a monomer CTU-6 shown below (0.5 mmol), a monomer CTU-2 shown below (0.5 mmol), a monomer CU-1 shown below (0.5 mmol), toluene (6.0 mL) and Aliquat 336 (a registered trademark) (10 mg), and the prepared Pd catalyst solution (0.1 mL) was then added. After stirring for 30 minutes, a 3 mol/L aqueous solution of potassium hydroxide (1 mL) was added. All of the solutions were deaerated by nitrogen bubbling for at least 30 minutes prior to use. The resulting mixture was heated and refluxed for 2 hours. All the operations up to this point were conducted under a stream of nitrogen.

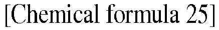

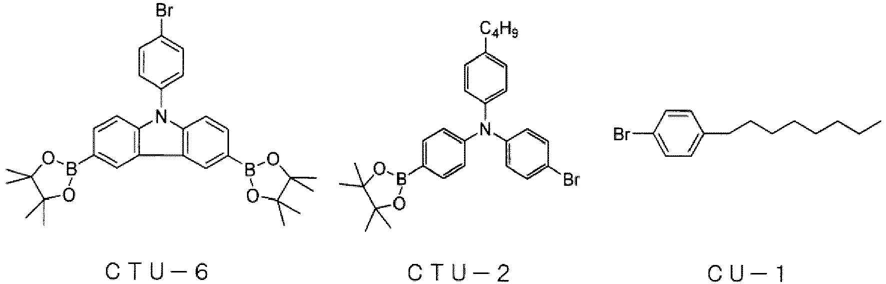

After completion of the reaction, the organic layer was washed with water, and was then poured into methanol-water (9:1). The resulting precipitate was collected by filtration under reduced pressure, and washed with methanol-water (9:1). The obtained precipitate was dissolved in toluene, and re-precipitated from methanol. The thus obtained precipitate was collected by filtration under reduced pressure and then dissolved in toluene, and a metal adsorbent ("Triphenylphosphine, polymer-bound on styrene-divinylbenzene copolymer", manufactured by Strem Chemicals Inc., 200 mg per 100 mg of the precipitate) was then added to the solution and stirred overnight. Following completion of the stirring, the metal adsorbent and other insoluble matter were removed by filtration, and the filtrate was concentrated using a rotary evaporator. The concentrate was dissolved in toluene, and then re-precipitated from methanol-acetone (8:3). The thus produced precipitate was collected by filtration under reduced pressure and washed with methanol-acetone (8:3). The thus obtained precipitate was then dried under vacuum to obtain a branched polymer 9.

The obtained branched polymer 9 had a number average molecular weight of 8,900, a weight average molecular weight of 25,000, and a dispersity of 2.81.

### [Example 12]

### (Branched Polymer 10)

With the exception of altering the monomers to the monomer CTU-6 shown above (0.6 mmol), the monomer CTU-2 shown above (0.5 mmol) and the monomer CU-1 shown above (0.6 mmol), synthesis of a branched polymer 10 was performed in the same manner as Example 11. The obtained branched polymer 10 had a number average molecular weight of 8,300, a weight average molecular weight of 26,200, and a dispersity of 3.16.

### [Example 13]

### (Branched Polymer 11)

With the exception of altering the monomers to the monomer CTU-6 shown above (0.4 mmol), the monomer CTU-2 shown above (0.5 mmol) and the monomer CU-1 shown above (0.4 mmol), synthesis of a branched polymer 11 was performed in the same manner as Example 11. The obtained branched polymer 11 had a number average molecular weight of 8,200, a weight average molecular weight of 24,100, and a dispersity of 2.94.

### [Example 14]

### (Branched Polymer 12)

With the exception of altering the monomers to the monomer CTU-6 shown above (0.3 mmol), the monomer CTU-2 shown above (0.5 mmol) and the monomer CU-1 shown above (0.3 mmol), synthesis of a branched polymer 12 was performed in the same manner as Example 11. The obtained branched polymer 12 had a number average molecular weight of 7,500, a weight average molecular weight of 23,000, and a dispersity of 3.07.

### [Comparative Example 7]

### (Branched Polymer 13)

With the exception of altering the monomers to a monomer CTU-7 shown below (0.2 mmol), the monomer CTU-5 shown above (0.5 mmol) and the monomer CU-1 shown above (0.4 mmol), synthesis of a branched polymer 13 was performed in the same manner as Example 11. The obtained branched polymer 13 had a number average molecular weight of 6,500, a weight average molecular weight of 30,300, and a dispersity of 4.66.

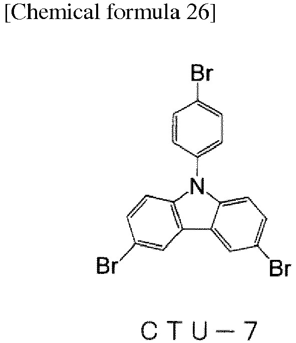

### [Comparative Example 8]

### (Branched Polymer 14)

With the exception of altering the monomers to the monomer CTU-7 shown above (0.16 mmol), the monomer CTU-5 shown above (0.5 mmol) and the monomer CU-1 shown above (0.5 mmol), synthesis of a branched polymer 14 was performed in the same manner as Example 11. The obtained branched polymer 14 had a number average molecular weight of 4,300, a weight average molecular weight of 28,100, and a dispersity of 6.53.

### [Comparative Example 9]

### (Branched Polymer 15)

With the exception of altering the monomers to the monomer CTU-7 shown above (0.25 mmol), the monomer CTU-5 shown above (0.5 mmol) and the monomer CU-1 shown above (0.25 mmol), synthesis of a branched polymer 15 was performed in the same manner as Example 11. The obtained branched polymer 15 had a number average molecular weight of 5,100, a weight average molecular weight of 120,300, and a dispersity of 23.59.

The monomers used in preparing the branched polymers, and the molecular weights and the like of the obtained branched polymers are summarized below in Table 4.

### [Table 4]

**Table 4**

| | Branched polymer | Monomers | Number average molecular weight | Weight average molecular weight | Dispersity |
|---|---|---|---|---|---|
| Example 11 | 9 | CTU-6 (0.5) | 8,900 | 25,000 | 2.81 |
| | | CTU-2 (0.5) | | | |
| | | CU-1 (0.5) | | | |
| Example 12 | 10 | CTU-6 (0.6) | 8,300 | 26,200 | 3.16 |
| | | CTU-2 (0.5) | | | |
| | | CU-1 (0.6) | | | |
| Example 13 | 11 | CTU-6 (0.4) | 8,200 | 24,100 | 2.94 |
| | | CTU-2 (0.5) | | | |
| | | CU-1 (0.4) | | | |
| Example 14 | 12 | CTU-6 (0.3) | 7,500 | 23,000 | 3.07 |
| | | CTU-2 (0.5) | | | |
| | | CU-1 (0.3) | | | |
| Comparative Example 7 | 13 | CTU-7 (0.2) | 6,500 | 30,300 | 4.66 |
| | | CTU-5 (0.5) | | | |
| | | CU-1 (0.4) | | | |
| Comparative Example 8 | 14 | CTU-7 (0.16) | 4,300 | 28,100 | 6.53 |
| | | CTU-5 (0.5) | | | |
| | | CU-1 (0.5) | | | |
| Comparative Example 9 | 15 | CTU-7 (0.25) | 5,100 | 120,300 | 23.59 |
| | | CTU-5 (0.5) | | | |
| | | CU-1 (0.25) | | | |

Based on the molecular weights and numbers and types of reactive functional groups in the monomers used, and the molecular weight values of the branched polymers, it was assumed that the branched polymers 9 to 12 each had a partial structure (1). The branched polymers 9 to 12 each had a small dispersity regardless of the monomer blend ratio, and variations in the molecular weight and dispersity values between the branched polymers 9 to 12 were small.

### <Production and Evaluation of Organic EL Elements>

The following examples relate to embodiments in which an organic layer (organic thin film) formed using an organic electronic material (an ink composition) containing a branched polymer was used for both the hole injection layer and the hole transport layer of an organic EL element.

### [Example 15]

Under a nitrogen atmosphere, the branched polymer 1 (10.0 mg), the ionic compound 1 shown above (0.5 mg) and toluene (2.3 mL) were mixed together to prepare an ink composition. The ink composition was spin-coated at a rotational rate of 3,000 min⁻¹ onto a glass substrate on which ITO had been patterned with a width of 1.6 mm, and was then cured by heating at 230°C for 30 minutes on a hot plate, thus forming a hole injection layer (30 nm).

Subsequently, the branched polymer 9 (10.0 mg) and toluene (2.3 mL) were mixed together to prepare another ink composition. This ink composition was spin-coated at a rotational rate of 3,000 min⁻¹ onto the above hole injection layer, and was then dried by heating at 230°C for 30 minutes on a hot plate, thus forming a hole transport layer (30 nm).

The glass substrate was then transferred into a vacuum deposition apparatus, and layers of CBP:Ir(ppy)₃ (94:6, 30 nm), BAlq (10 nm), TPBi (30 nm), Liq (2.0 nm) and Al (150 nm) were deposited in that order on top of the hole transport layer using deposition methods. An encapsulation treatment was then performed to complete production of an organic EL element.

### [Examples 16 to 18 and Comparative Examples 10 to 12]

With the exceptions of using the branched polymers shown below in Table 5 in the formation steps for the hole injection layer and the hole transport layer, organic EL elements were produced in the same manner as Example 15.

The organic electronic materials used in forming the hole injection layer and the hole transport layer in the organic EL elements of Examples 15 to 18 and Comparative Examples 10 to 12 are summarized in Table 5.

### [Table 5]

**Table 5**

| | Organic electronic material used in hole injection layer | Organic electronic material used in hole transport layer |
|---|---|---|
| Example 15 | Branched polymer 1 | Branched polymer 9 |
| | ionic compound 1 | |
| Example 16 | Branched polymer 1 | Branched polymer 10 |
| | ionic compound 1 | |
| Example 17 | Branched polymer 1 | Branched polymer 11 |
| | ionic compound 1 | |
| Example 18 | Branched polymer 1 | Branched polymer 12 |
| | ionic compound 1 | |
| Comparative Example 10 | Branched polymer 6 | Branched polymer 13 |
| | ionic compound 1 | |
| Comparative Example 11 | Branched polymer 6 | Branched polymer 14 |
| | ionic compound 1 | |
| Comparative Example 12 | Branched polymer 6 | Branched polymer 15 |
| | ionic compound 1 | |

When a voltage was applied to the organic EL elements obtained in Examples 15 to 18 and Comparative Examples 10 to 12, green light emission was confirmed in each case. For each organic EL element, the emission efficiency at a luminance of 5,000 cd/m² and the emission lifespan (luminance half-life) when the initial luminance was 5,000 cd/m² were measured. The measurement results are shown in Table 6. Measurement of the luminance was performed using a spectroradiometer SR-3AR manufactured by Topcon Technohouse Corporation.

### [Table 6]

**Table 6**

| | Emission efficiency (cd/A) | Emission efficiency Δ (difference between maximum and minimum) | Emission lifespan (h) | Emission lifespan Δ (difference between maximum and minimum) |
|---|---|---|---|---|
| Example 15 | 32.5 | 0.7 | 283.2 | 12.4 |
| Example 16 | 32.0 | | 275.6 | |
| Example 17 | 31.8 | | 288.0 | |
| Example 18 | 32.3 | | 278.9 | |
| Comparative Example 10 | 29.2 | 0.9 | 263.1 | 20.8 |
| Comparative Example 11 | 30.1 | | 242.3 | |
| Comparative Example 12 | 29.7 | | 251.9 | |

As illustrated in Table 6, in each of Examples 15 to 18, a long-life organic EL element having excellent drive stability was able to be obtained. Further, in Examples 15 to 18, superior emission efficiency results were also obtained. Furthermore, in Examples 15 to 18, the variation across Examples 15 to 18 was small.

The effects of embodiments included in the present invention have been illustrated above using a series of examples. However, the present invention is not limited to the branched polymers used in the above examples, and provided the materials do not depart from the scope of the present invention, organic electronic elements can be obtained in a similar manner using other branched polymers.

By using the branched polymer production method that represents an embodiment of the present invention, branched polymers having a branched structure can be obtained with ease. Further, excellent organic electronic materials can be provided.

Moreover, by using the branched polymer production method according to an embodiment of the present invention, a branched polymer of stable quality can be produced, largely independent of the monomer blend ratio used during production. The branched polymer production method according to an embodiment of the present invention is particularly useful in the mass-production of an organic electronic material.

By using the branched polymers P1 and P2 according to embodiments of the present invention, excellent organic electronic materials can be provided.

### Reference Signs List

- 1:: Anode
- 2:: Hole injection layer
- 3:: Light-emitting layer
- 4:: Electron injection layer
- 5:: Cathode
- 6:: Substrate
- 7:: Hole transport layer
- 8:: Electron transport layer

## Claims

1. A branched polymer production method, comprising reacting a monomer component containing at least reactive monomers (1) and (2) described below:
a reactive monomer (1) having at least a conjugation unit and three or more reactive functional groups bonded to the conjugation unit, wherein the three or more reactive functional groups include two types of reactive functional groups that are mutually different, and
a reactive monomer (2) having at least a conjugation unit and two reactive functional groups bonded to the conjugation unit, wherein one of the two reactive functional groups is a group capable of reacting with one type of reactive functional group selected from among the two types of reactive functional groups, and another of the two reactive functional groups is a group capable of reacting with another type of reactive functional group selected from among the two types of reactive functional groups.

2. The branched polymer production method according to Claim 1, wherein the monomer component further comprises a reactive monomer (3) described below:
a reactive monomer (3) having at least a conjugation unit and one reactive functional group bonded to the conjugation unit, wherein the one reactive functional group is capable of reacting with one type of reactive functional group selected from among the two types of reactive functional groups.

3. The branched polymer production method according to Claim 2, wherein the reactive monomer (3) comprises a reactive monomer (3C) described below:
a reactive monomer (3C) having at least a conjugation unit, one reactive functional group bonded to the conjugation unit, and a group containing one or more polymerizable functional groups that is bonded to the conjugation unit, wherein the one reactive functional group is capable of reacting with one type of reactive functional group selected from among the two types of reactive functional groups.

4. A branched polymer comprising a reaction product of a monomer component containing at least reactive monomers (1) and (2) described below:
a reactive monomer (1) having at least a conjugation unit and three or more reactive functional groups bonded to the conjugation unit, wherein the three or more reactive functional groups include two types of reactive functional groups that are mutually different, and
a reactive monomer (2) having at least a conjugation unit and two reactive functional groups bonded to the conjugation unit, wherein one of the two reactive functional groups is a group capable of reacting with one type of reactive functional group selected from among the two types of reactive functional groups, and another of the two reactive functional groups is a group capable of reacting with another type of reactive functional group selected from among the two types of reactive functional groups.

5. The branched polymer according to Claim 4, wherein the monomer component further comprises a reactive monomer (3) described below:
a reactive monomer (3) having at least a conjugation unit and one reactive functional group bonded to the conjugation unit, wherein the one reactive functional group is capable of reacting with one type of reactive functional group selected from among the two types of reactive functional groups.

6. The branched polymer according to Claim 5, wherein the reactive monomer (3) comprises a reactive monomer (3C) described below:
a reactive monomer (3C) having at least a conjugation unit, one reactive functional group bonded to the conjugation unit, and a group containing one or more polymerizable functional groups that is bonded to the conjugation unit, wherein the one reactive functional group is capable of reacting with one type of reactive functional group selected from among the two types of reactive functional groups.

7. A branched polymer comprising at least a partial structure (1) shown below: 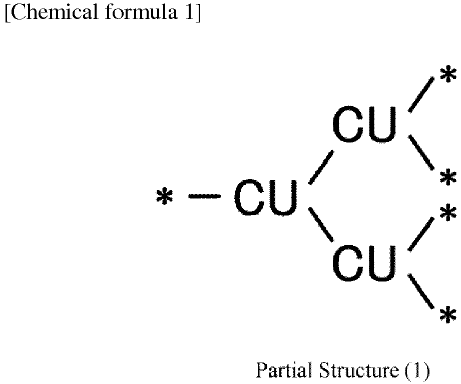 wherein each CU independently represents a conjugation unit, and each conjugation unit may have a substituent.

8. The branched polymer according to Claim 7, further comprising a partial structure (2) shown below:
[Chemical formula 2]
*** - CU - *** Partial structure (2)
wherein CU represents a conjugation unit, and the conjugation unit may have a substituent.

9. The branched polymer according to Claim 7 or 8, further comprising a partial structure (3) shown below:
[Chemical formula 3]
*** - CU** Partial structure (3)
wherein CU represents a conjugation unit, and the conjugation unit may have a substituent.

10. An organic electronic material comprising a branched polymer produced using the branched polymer production method according to any one of Claims 1 to 3, or the branched polymer according to any one of Claims 4 to 9.

11. The organic electronic material according to Claim 10, wherein the branched polymer has a polymerizable functional group, and the organic electronic material further comprises a polymerization initiator.

12. The organic electronic material according to Claim 10 or 11, further comprising an electron-accepting compound.

13. An ink composition comprising a branched polymer produced using the branched polymer production method according to any one of Claims 1 to 3, the branched polymer according to any one of Claims 4 to 9, or the organic electronic material according to any one of Claims 10 to 12, and a solvent.

14. An organic layer formed using a branched polymer produced using the branched polymer production method according to any one of Claims 1 to 3, the branched polymer according to any one of Claims 4 to 9, the organic electronic material according to any one of Claims 10 to 12, or the ink composition according to Claim 13.

15. An organic layer comprising a branched polymer produced using the branched polymer production method according to any one of Claims 1 to 3, the branched polymer according to any one of Claims 4 to 9, or the organic electronic material according to any one of Claims 10 to 12.

16. An organic electronic element comprising at least one of the organic layer according to Claim 14 or 15.

17. An organic electroluminescent element comprising at least one of the organic layer according to Claim 14 or 15.

18. An organic electroluminescent element comprising at least a hole injection layer, wherein the hole injection layer is the organic layer according to Claim 14 or 15.

19. An organic electroluminescent element comprising at least a hole transport layer, wherein the hole transport layer is the organic layer according to Claim 14 or 15.

20. A display element comprising the organic electroluminescent element according to any one of Claims 17 to 19.

21. An illumination device comprising the organic electroluminescent element according to any one of Claims 17 to 19.

22. A display device comprising the illumination device according to Claim 21, and a liquid crystal element as a display unit.
